# EUROPEAN PATENT APPLICATION

(11) **EP 4 205 904 A1**
(43) Date of publication of application: **05.07.2023**
(21) Application number: 21861445.1
(22) Date of filing: 20.08.2021
(51) Int. Cl.: B24B 37/24, H01L 21/304, B01J 13/16

(54) **POLYMERIZABLE FUNCTIONAL GROUP-CONTAINING MICROBALLOON**

(30) Priority: 26.08.2020 JP 2020142834
(71) Applicant: Tokuyama Corporation, Shunan-shi, Yamaguchi 745-8648 (JP)
(72) Inventor: SHIMIZU, Yasutomo, Shunan-shi, Yamaguchi 745-8648 (JP); KAWASAKI, Takayoshi, Shunan-shi, Yamaguchi 745-8648 (JP)
(74) Representative: Gerauer, Marc Philippé
(86) International application number: PCT/JP2021/030643
(87) International publication number: WO 2022/045018

(57) **Abstract**

A microballoon according to the present invention contains, in a surface layer of the microballoon, a polymerizable functional group having reactivity with an iso(thio)cyanate group, and the microballoon has a particle diameter of 10 pm to 200 pm. When the microballoon according to the present invention is used in a CMP polishing pad, excellent polishing characteristics and excellent durability of the polishing pad can be exhibited.

## Description

### Technical Field

The present invention relates to a novel microballoon.

### Background Art

Heretofore, microballoons have been used in various fields including agriculture, medicines, fragrances, liquid crystals, adhesives, electronic material parts and building materials, as microballoons encapsulating a skincare component, a fragrance component, a dye component, an analgesic component, a deodorant component, an antioxidant component, a bactericidal component, a heat storage component or the like, or as hollow microballoons that are hollow inside of the microballoons.

Recently, in particular, hollow microballoons have been investigated for the purpose of forming fine pores in polyurethane(urea)-made polishing pad for chemical mechanical polishing (CMP) of wafer polishing.

Heretofore, as a microballoon for the CMP polishing pad, a microballoon formed of a vinylidene chloride resin or the like in which inorganic particles are sprinkled on a surface of the microballoon has been known in order to improve dispersibility in a polyurethane (urea) resin used as a base material of the CMP polishing pad, but the inorganic particles may cause defects in a wafer.

Therefore, the present inventors have proposed a polishing pad for CMP having excellent polishing characteristics, by using microballoon formed of a polyurethane(urea) resin membrane having high elasticity and having good compatibility with a polyurethane(urea) resin, in a CMP polishing pad (see PTL 1).

However, with recent micronization of semiconductor interconnections, polishing pads for CMP with higher performance have been demanded, and further improvements in durability and resin physical properties of microballoon have been demanded.

### Citation List

### Patent Literature

PTL 1: WO 2019/198675

### Summary of Invention

### Technical Problem

As a result of studies made by the present inventors, it has been found that, when the microballoon described in PTL 1 is used in the CMP polishing pad, the microballoon may detach from the CMP polishing pad during polishing, which is determined to be one of causes of scratches on an object to be polished.

Therefore, an object of the present invention is to provide a microballoon capable of exhibiting excellent polishing characteristics while preventing detachment from a CMP polishing pad when the microballoon is used in the CMP polishing pad.

### Solution to Problem

As a result of intensive studies for solving the above-described problems, the present inventors have found that, when a CMP polishing pad is prepared using a microballoon containing, in a surface layer of the microballoon, a polymerizable functional group having reactivity with an iso(thio)cyanate group, the microballoon is less likely to be detached from the CMP polishing pad during CMP polishing. In addition, the present inventors have found that it is possible not only to prevent scratches caused by contact between the detached microballoon and an object to be polished, but also to prevent abrasion caused by contact between the detached microballoon and the CMP polishing pad. Further, when a microballoon having a particle diameter of 10 pm to 200 pm is used, an excellent polishing rate can be exhibited. Therefore, it has been found that the above-described problems can be solved by using the above-described microballoon, leading to completion of the present invention.

That is, the present invention provides a microballoon containing, in a surface layer of the microballoon, a polymerizable functional group having reactivity with an iso(thio)cyanate group, and the microballoon has a particle diameter of 10 pm to 200 pm.

The present invention further provides a CMP polishing pad containing the microballoon.

The present invention relates to the following [1] to [9].
[1] A microballoon containing a surface layer and having a particle diameter of 10 pm to 200 pm, the surface layer having a polymerizable functional group having reactivity with an iso(thio)cyanate group.
[2] The microballoon according to [1], wherein the polymerizable functional group having reactivity with an iso(thio)cyanate group comprises at least one group selected from the group consisting of a hydroxy group, an amino group, and a thiol group.
[3] The microballoon according to [1] or [2], wherein an amount of the polymerizable functional group having reactivity with an iso(thio)cyanate group contained in the surface layer is 0.75 mmol/g or more per unit weight of the microballoon.
[4] The microballoon according to any one of [1] to [3], formed of at least one resin selected from the group consisting of a urethane (urea) resin, a melamine resin, a urea resin, and an amide resin.
[5] The microballoon according to any one of [1] to [4], having an ash content of 0.5 parts by mass or less per 100 parts by mass of the microballoon.
[6] The microballoon according to any one of [1] to [5], having a bulk density of 0.01 g/cm³to 0.5 g/cm³.
[7] A polyurethane (urea) resin containing the microballoon according to any one of [1] to [6].
[8] A CMP polishing pad containing the polyurethane (urea) resin according to [7].
[9] The CMP polishing pad according to [8], in which the polyurethane (urea) resin has a Shore hardness of 40A to 80D and a density of 0.60 g/cm³ to 0.95 g/cm³.

### Advantageous Effects of Invention

The microballoon according to the present invention is characterized by containing, in the surface layer of the microballoon, the polymerizable functional group having reactivity with an iso(thio)cyanate group, and having a particle diameter of 10 pm to 200 pm.

In addition, the CMP polishing pad containing the microballoon can exhibit excellent polishing characteristics and excellent durability. For example, it is possible to exhibit a high polishing rate and reduce defects generated in a wafer.

Further, the microballoon according to the present invention can be used in many fields such as heat-sensitive recording materials, agricultural chemicals, drugs, fragrances, liquid crystals, adhesives, electronic material parts, and building materials, in addition to the use in the CMP polishing pad.

### Description of Embodiments

A microballoon according to the present invention contains a surface layer and has a particle diameter of 10 pm to 200 pm. The surface layer has a polymerizable functional group having reactivity with an iso(thio)cyanate group. In the present description, the iso(thio)cyanate group means one or both of an isocyanate group and an isothiocyanate group.

The microballoon according to the present invention is a particle having an outer shell, and the inside of the microballoon may be hollow or the microballoon may contain an organic solvent or the like therein. The outer shell is formed of a resin, and a preferred resin is as described later.

In addition, the phrase "containing, in a surface layer of the microballoon, a polymerizable functional group" means that the resin forming the outer shell of the microballoon contains a polymerizable functional group.

First, the microballoon will be described. The polymerizable functional group having reactivity with an iso(thio)cyanate group contained in the surface layer of the microballoon according to the present invention is not particularly limited as long as it is a polymerizable functional group having reactivity with an iso(thio)cyanate group. Among these, preferred examples of the polymerizable functional group include a hydroxy group, an amino group, and a thiol group, and particularly preferred examples of the polymerizable functional group include a hydroxy group and an amino group.

In the present invention, a method of confirming the presence or absence of a polymerizable functional group having reactivity with an iso(thio)cyanate group contained in the surface layer of the microballoon is not particularly limited, and examples of the method include a method of adding a microballoon to a compound containing an iso(thio)cyanate group and confirming whether the number of moles of the iso(thio)cyanate group changes before and after the addition of the microballoon. At this time, it is considered that when a polyfunctional iso(thio)cyanate compound is used as the compound having an iso(thio)cyanate group, crosslinking and thickening occur, and thus it is preferred to use a monofunctional isocyanate compound. As a specific example, the presence or absence of the polymerizable functional group having reactivity with an iso(thio)cyanate group can be determined by adding a microballoon to butyl isocyanate, sufficiently stirring the mixture, and then quantifying an iso(thio)cyanate group by using a back titration method in accordance with JIS K 7301. Here, an example in which butyl isocyanate is used is shown, but the present invention is not limited thereto, and another compound having an iso(thio)cyanate group may be used.

When the above-described method is described in detail, butyl isocyanate (or a butyl isocyanate solution having a known concentration) and di-n-butylamine, which has a clearly excessive amount than an amount of isocyanate groups contained in butyl isocyanate, are added to a dry solvent having no reactivity with an isocyanate group, and the total isocyanate groups contained in butyl isocyanate are reacted with di-n-butylamine. Next, di-n-butylamine that is not consumed (not involved in the reaction) is titrated with an acid to determine an amount of the consumed di-n-butylamine. Since the consumed di-n-butylamine has the same amount as the isocyanate group contained in butyl isocyanate, an isocyanate equivalent can be determined. In order to confirm the presence or absence of the polymerizable functional group having reactivity with an iso(thio)cyanate group contained in the surface layer of the microballoon according to the present invention, it is sufficient to confirm a decrease in the isocyanate equivalent of butyl isocyanate after mixing the microballoon and butyl isocyanate (or a butyl isocyanate solution having a known concentration) in which the isocyanate equivalent is known. For example, when the isocyanate equivalent in butyl isocyanate is reduced, it can be seen that the microballoon contains, in the surface layer of the microballoon, the polymerizable functional group having reactivity with an iso(thio)cyanate group.

In the present invention, an amount of the polymerizable functional group having reactivity with an iso(thio)cyanate group contained in the surface layer is preferably 0.75 mmol/g or more, more preferably 1 mmol/g or more, and most preferably 2 mmol/g or more per unit weight of the microballoon. Accordingly, when the microballoon is used in the CMP polishing pad, the microballoon can be prevented from being detached from the CMP polishing pad. The amount per unit weight of the microballoon of the polymerizable functional group having reactivity with an iso(thio)cyanate group contained in the surface layer can be measured by using the back titration method in accordance with JIS K 7301, as described above.

The microballoon according to the present invention needs to have a particle diameter of 10 pm to 200 pm, more preferably 10 pm to 100 pm, and most preferably 10 pm to 50 pm. When the microballoon is blended into the CMP polishing pad within this range, excellent polishing characteristics can be exhibited.

The particle diameter of the microballoon means an average particle diameter of microballoons. The average particle diameter of the microballoons can be measured by using a known method, specifically, an image analysis method. A particle size can be easily measured by using the image analysis method. The average particle diameter is an average particle diameter of primary particles. The average particle diameter can be measured by using the image analysis method using, for example, an optical microscope and a scanning electron microscope.

Specifically, particle diameters of a plurality of (at least 20 or more) microballoons are measured by using the image analysis method, and an average particle diameter is determined as an average value thereof.

In addition, the particle diameter of the microballoon is a diameter of an observed particle when a shape of the observed particle is a circle, and is a maximum linear distance between any two points on an outer periphery of an observed particle when a shape of the observed particle is a shape other than a circle.

When the microballoon according to the present invention is a hollow microballoon, a bulk density is not particularly limited, and is preferably 0.01 g/cm³ to 0.5 g/cm³, and more preferably 0.02 g/cm³ to 0.3 g/cm³. Within this range, it is possible to form optimum pores on a polished surface while ensuring physical properties of the CMP polishing pad.

An ash content in the microballoon according to the present invention is not particularly limited, and is preferably 0.5 parts by mass or less, more preferably 0.3 parts by mass or less, still more preferably 0.1 parts by mass or less, and most preferably cannot be measured, per 100 parts by mass of the microballoon in a method described in Examples to be described later. Within this range, defects generated in a wafer can be reduced when the microballoon is used in the CMP polishing pad.

Considering that the microballoon according to the present invention is introduced with the polymerizable functional group having reactivity with an iso(thio)cyanate group in the surface layer of the microballoon, it is preferred that the microballoon is a microballoon formed of at least one resin selected from the group consisting of a urethane (urea) resin, a melamine resin, a urea resin, and an amide resin. These resins form the outer shell of the microballoon.

In the present invention, the phrase "introducing the polymerizable functional group" refers not only to a case in which a polymerizable functional group is introduced, but also to a case in which a polymerizable functional group originally contained in a resin to be used is introduced.

In the present invention, the urethane (urea) resin is a resin obtained by a reaction of a compound containing an iso(thio)cyanate group with a compound containing at least one group selected from the group consisting of a hydroxy group, a thiol group, and an amino group, and is a resin having a urethane bond in a main chain, a resin having a urea bond in a main chain, or a resin having both a urethane bond and a urea bond in a main chain (including a case in which oxygen atoms of a bond part are substituted with sulfur atoms).

The melamine resin is a resin obtained by polycondensation of formaldehyde with a polyfunctional amine containing melamine in a main chain, the urea resin is a resin obtained by polycondensation of formaldehyde with urea (further including a polyfunctional amine) in a main chain, and the amide resin is a resin having an amide bond in a main chain.

In the present invention, examples of a polymerizable monomer forming these resins include, but are not limited to, the following.

When the microballoon is formed of a urethane (urea) resin, a microballoon formed of a urethane (urea) resin can be prepared by using, as a polymerizable monomer, (A1) a polyfunctional iso(thio)cyanate compound containing at least two iso(thio)cyanate groups (hereinafter also referred to as a polyfunctional iso(thio)cyanate compound (A1) or a component (A1)), and at least one compound selected from (A2) a poly(thi)ol compound containing, in at least one molecule, two or more groups selected from the group consisting of a hydroxy group and a thiol group (hereinafter also referred to as a poly(thi)ol compound (A2) or a component (A2)), (A3) a polyfunctional amine compound containing at least two amino groups (hereinafter also referred to as a polyfunctional amine compound (A3) or a component (A3)), and (A4) a compound containing at least both a hydroxy group and an amino group (hereinafter also referred to as a component (A4)).

When the microballoon is formed of a melamine resin, a microballoon formed of a melamine resin can be prepared by using (A5) a melamine formaldehyde prepolymer compound.

When the microballoon is formed of a urea resin, a microballoon formed of a urea resin can be prepared by using (A6) a urea formaldehyde prepolymer compound.

When the microballoon is formed of an amide resin, a microballoon formed of an amide resin can be prepared by using the polyfunctional amine compound containing at least two amino groups (A3) and (A7) a polyfunctional carboxylic acid containing at least two carboxy groups.

A method for introducing the polymerizable functional group having reactivity with an iso(thio)cyanate group contained in a surface layer of the microballoon is not particularly limited. However, when the microballoon is formed of a urethane (urea) resin, the hydroxy group, the thiol group, and a part of the amino group in the components (A2) to (A4) may be made remaining on the surface layer, or the isocyanate group may be made remaining on the surface layer and then the isocyanate group may be modified to an amino group by a reaction with water, or after the microballoon is prepared by using the components (A2) to (A4) having reaction active sites in advance, a hydroxy group, a thiol group, and an amino group may be introduced by modifying the surface layer.

When the microballoon is formed of a melamine resin, an amino group derived from melamine in an unreacted site may be used, or the microballoon may be prepared by using melamine having introduced reaction active sites in advance and then a hydroxy group, an amino group, and a thiol group may be introduced by using the reaction active sites.

When the microballoon is formed of a urea resin, an amino group derived from urea in an unreacted site may be used, or the microballoon may be prepared by using urea having introduced reaction active sites in advance and then a hydroxy group, an amino group, and a thiol group may be introduced by using the reaction active sites.

When the microballoon is formed of an amide resin, a part of the amino group in the component (A3) may be made remaining, or a part of an amino group in melamine may be modified with a compound containing a hydroxy group, an amino group, and a thiol group in advance, or the microballoon may be prepared by using the component (A7) or the component (A3) having introduced reaction active sites in advance and then a hydroxy group, an amino group, and a thiol group may be introduced by using the reaction active sites.

The reaction active site is not particularly limited, and examples thereof include a radically polymerizable group.

Specific examples of the polymerizable monomer are shown below.

### <Polyfunctional isocyanate compound containing at least two iso(thio)cyanate groups (A1)>

The polyfunctional iso(thio)cyanate compound (A1) used in the present invention is a compound containing at least two groups selected from the group consisting of an isocyanate group and an isothiocyanate group. Of course, a compound containing two groups, i.e., an isocyanate group and an isothiocyanate group, can also be selected. Among these, a compound containing 2 to 6 iso(thio)cyanate groups in a molecule is preferred, a compound containing 2 to 4 iso(thio)cyanate groups is more preferred, and a compound having 2 to 3 iso(thio)cyanate groups is still more preferred.

The component (A1) may be (A12) a urethane prepolymer containing an unreacted iso(thio)cyanate group prepared by a reaction of a bifunctional iso(thio)cyanate compound to be described later with a bifunctional poly(thi)ol compound or a bifunctional amine compound to be described later (hereinafter also referred to as a urethane prepolymer (A12) or a component (A12)). The urethane prepolymer (A12) is not particularly limited as long as it contains an unreacted isocyanate group.

The iso(thio)cyanate compound (A1) can be broadly classified into an aliphatic isocyanate, an alicyclic isocyanate, an aromatic isocyanate, an isothiocyanate, other isocyanates, and the urethane prepolymer (A12). In addition, as the component (A1), one type of compound can be used, and a plurality of types of compounds can be used. When a plurality of types of compounds are used, a mass to be a standard is a total amount of the plurality of types of compounds. Specific examples of the component (A1) are shown below.

### (Aliphatic isocyanate)

Bifunctional isocyanate monomers (corresponding to the bifunctional iso(thio)cyanate compound forming the urethane prepolymer) such as ethylene diisocyanate, trimethylene diisocyanate, tetramethylene diisocyanate, hexamethylene di-isocyanate, octamethylene diisocyanate, nonamethylene diisocyanate, 2,2'-dimethylpentane diisocyanate, 2,2,4-trimethylhexamethylene diisocyanate, decamethylene diisocyanate, butene diisocyanate, 1,3-butadiene-1,4-diisocyanate, 2,4,4-trimethylhexamethylene diisocyanate, 1,6,11-trimethylundecamethylene diisocyanate, 1,3,6-trimethylhexamethylene diisocyanate, 1,8-diisocyanato-4-isocyanatomethyloctane, 2,5,7-trimethyl-1,8-diisocyanato-5-isocyanatomethyloctane, bis(isocyanatoethyl) carbonate, bis(isocyanatoethyl)ether, 1,4-butylene glycol dipropyl ether-ω,ω'-diisocyanate, lysine diisocyanate methyl ester, and 2,4,4-trimethylhexamethylene diisocyanate.

### (Alicyclic isocyanate)

Bifunctional isocyanate monomers (corresponding to the bifunctional iso(thio)cyanate compound forming the urethane prepolymer) such as isophorone diisocyanate, (bicyclo[2.2.1]heptane-2,5-diyl)bismethylene diisocyanate, (bicyclo[2.2.1]heptane-2,6-diyl)bismethylene diisocyanate, 2β,5α-bis(isocyanate) norbornane, 2β,5β-bis(isocyanate) norbornane, 2β,6α-bis(isocyanate) norbornane, 2β,6β-bis(isocyanate) norbornane, 2,6-di(isocyanatomethyl)furan, 1,3-bis(isocyanatomethyl) cyclohexane, dicyclohexylmethane-4,4'-diisocyanate, 4,4-isopropylidene bis(cyclohexyl isocyanate), cyclohexane diisocyanate, methylcyclohexane diisocyanate, dicyclohexyldimethylmethane diisocyanate, 2,2'-dimethyldicyclohexylmethane diisocyanate, bis(4-isocyanato-n-butylidene) pentaerythritol, dimer acid diisocyanate, 2,5-bis(isocyanatomethyl)-bicyclo[2,2,1]-heptane, 2,6-bis(isocyanatomethyl)-bicyclo[2,2,1]-heptane, 3,8-bis(isocyanatomethyl) tricyclodecane, 3,9-bis(isocyanatomethyl) tricyclodecane, 4,8-bis(isocyanatomethyl) tricyclodecane, 4,9-bis(isocyanatomethyl) tricyclodecane, 1,5-diisocyanate decalin, 2,7-diisocyanate decalin, 1,4-diisocyanate decalin, 2,6-diisocyanate decalin, bicyclo[4.3.0]nonane-3,7-diisocyanate, bicyclo[4.3.0]nonane-4,8-diisocyanate, bicyclo[2.2.1]-heptane-2,5-diisocyanate, and bicyclo[2.2.1]-heptane-2,6-diisocyanate, bicyclo[2,2,2]octane-2,5-diisocyanate, bicyclo[2,2,2]octane-2,6-diisocyanate, tricyclo[5.2.1.02.6]decane-3,8-diisocyanate, and tricyclo[5.2.1.02.6]decane-4,9-diisocyanate.

Polyfunctional isocyanate monomers such as 2-isocyanatomethyl-3-(3-isocyanatopropyl)-5-isocyanatomethyl-bicyclo[2,2,1]-heptane, 2-isocyanatomethyl-3-(3-isocyanatopropyl)-6-isocyanatomethyl-bicyclo[2,2,1] -heptane, 2-isocyanatomethyl-2-(3-isocyanatopropyl)-5-isocyanatomethyl-bicyclo[2,2,1]-heptane, 2-isocyanatomethyl-2-(3-isocyanatopropyl)-6-isocyanatomethyl-bicyclo[2,2,1]-heptane, 2-isocyanatomethyl-3-(3-isocyanatopropyl)-5-(2-isocyanatoethyl)-bicyclo[2,2,1]-heptane, 2-isocyanatomethyl-3-(3-isocyanatopropyl)-6-(2-isocyanatoethyl)-bicyclo[2,1,1]-heptane, 2-isocyanatomethyl-2-(3-isocyanatopropyl)-5-(2-isocyanatoethyl)-bicyclo[2,2,1]-heptane, 2-isocyanatomethyl-2-(3-isocyanatopropyl)-6-(2-isocyanatoethyl)-bicyclo[2,2,1]-heptane, and 1,3,5-tris(isocyanatomethyl) cyclohexane.

### (Aromatic isocyanate)

Bifunctional isocyanate monomers (corresponding to the bifunctional iso(thio)cyanate compound forming the urethane prepolymer) such as xylylene diisocyanate (o-,m-,p-), tetrachloro-m-xylylene diisocyanate, methylenediphenyl-4,4'-diisocyanate, 4-chloro-m-xylylene diisocyanate, 4,5-dichloro-m-xylylene diisocyanate, 2,3,5,6-tetrabromo-p-xylylene diisocyanate, 4-methyl-m-xylylene diisocyanate, 4-ethyl-m-xylylene diisocyanate, bis(isocyanatoethyl)benzene, bis(isocyanatopropyl)benzene, 1,3-bis(α,α-dimethyl isocyanatomethyl)benzene, 1,4-bis(α,α-dimethyl isocyanatomethyl)benzene, α,α,α',α'-tetramethylxylylene diisocyanate, bis(isocyanatobutyl)benzene, bis(isocyanatomethyl)naphthalene, bis(isocyanatomethyl)diphenyl ether, bis(isocyanatoethyl)phthalate, 2,6-di(isocyanatomethyl)furan, phenylene diisocyanate (o-,m-,p-), ethylphenylene diisocyanate, isopropylphenylene diisocyanate, dimethylphenylene diisocyanate, diethylphenylene diisocyanate, diisopropylphenylene diisocyanate, trimethylbenzene triisocyanate, benzene triisocyanate, 1,3,5-triisocyanate methylbenzene, 1,5-naphthalene diisocyanate, methylnaphthalene diisocyanate, biphenyl diisocyanate, 2,4-tolylene diisocyanate, 2,6-tolylene diisocyanate, 4,4'-diphenylmethane diisocyanate, 2,2'-diphenylmethane diisocyanate, 2,4'-diphenylmethane diisocyanate, 3,3'-dimethyldiphenylmethane-4,4'-diisocyanate, bibenzyl-4,4'-diisocyanate, bis(isocyanatophenyl)ethylene, 3,3'-dimethoxybiphenyl-4,4'-diisocyanate, phenyl isocyanate methyl isocyanate, phenyl isocyanate ethyl isocyanate, tetrahydronaphthylene diisocyanate, hexahydrobenzene diisocyanate, hexahydrodiphenylmethane-4,4'-diisocyanate, diphenyl ether diisocyanate, ethylene glycol diphenyl ether diisocyanate, 1,3-propylene glycol diphenyl ether diisocyanate, benzophenone diisocyanate, diethylene glycol diphenyl ether diisocyanate, dibenzofuran diisocyanate, carbazole diisocyanate, ethylcarbazole diisocyanate, dichlorocarbazole diisocyanate, 2,4-tolylene diisocyanate, and 2,6-tolylene diisocyanate.

Polyfunctional isocyanate monomers such as mesitylene triisocyanate, triphenylmethane triisocyanate, polymeric MDI, naphthalene triisocyanate, diphenylmethane-2,4,4'-triisocyanate, 3-methyldiphenylmethane-4,4',6-triisocyanate, and 4-methyl-diphenylmethane-2,3,4',5,6-pentaisocyanate.

### (Isothiocyanate)

Bifunctional isothiocyanates (corresponding to the bifunctional iso(thio)cyanate compound forming the urethane prepolymer) such as p-phenylene diisothiocyanate, xylylene-1,4-diisothiocyanate, and ethylidene diisothiocyanate.

### (Other isocyanates)

Examples of other isocyanates include polyfunctional isocyanates having a biuret structure, a uretdione structure, and an isocyanurate structure (for example, a method for modifying a biuret structure, a uretdione structure, and an isocyanurate structure of an aliphatic polyisocyanate is disclosed in JP 2004-534870 A), which contain diisocyanates such as hexamethylene diisocyanate or tolylene diisocyanate as a main raw material, and polyfunctional isocyanates as adducts with a polyol having three or more functional groups such as trimethylolpropane (disclosed in a publication ("Polyurethane Resin Handbook" edited by Keiji Iwata, and published by The Nikkan Kogyo Shimbun, Ltd. in 1987) or the like).

### (Urethane prepolymer (A12))

In the present invention, as the urethane prepolymer (A12), a urethane prepolymer obtained by reacting a bifunctional isocyanate compound selected from the component (A1) (compound exemplified as the component (A1)) with a bifunctional poly(thi)ol compound (A21) or a bifunctional amine compound (A31) to be described below is suitable.

Examples of the bifunctional poly(thi)ol compound (A21) include the following.

### (Bifunctional poly(thi)ol (A21))

### (Aliphatic diol)

Bifunctional polyol compounds such as ethylene glycol, diethylene glycol, propylene glycol, dipropylene glycol, butylene glycol, 1,5-dihydroxypentane, 1,6-dihydroxyhexane, 1,7-dihydroxyheptane, 1,8-dihydroxyoctane, 1,9-dihydroxynonane, 1,10-dihydroxydecane, 1,11-dihydroxyundecane, 1,12-dihydroxydodecane, neopentyl glycol, glyceryl monooleate, monoelaidin, polyethylene glycol, 3-methyl-1,5-dihydroxypentane, dihydroxyneopentyl, 2-ethyl-1,2-dihydroxyhexane, 2-methyl-1,3-dihydroxypropane, a polyester polyol (compound containing hydroxy groups only at both terminals obtained by a condensation reaction of a polyol with a polybasic acid), a polyether polyol (compound containing hydroxy groups only at both terminals of a molecule obtained by ring-opening polymerization of alkylene oxides or a reaction of a compound containing two or more active hydrogen-containing groups in a molecule with an alkylene oxide, and modified products thereof), a polycaprolactone polyol (compound containing hydroxy groups only at both terminals of a molecule obtained by ring-opening polymerization of ε-caprolactone), a polycarbonate polyol (compound containing hydroxy groups only at both terminals of a molecule obtained by phosgenation of one or more types of low molecular weight polyols, or compound containing hydroxy groups only at both terminals of a molecule obtained by transesterification using ethylene carbonate, diethyl carbonate, diphenyl carbonate, and the like), and a polyacrylic polyol (polyol compound containing hydroxy groups only at both terminals of a molecule obtained by polymerizing a (meth)acrylate ester or a vinyl monomer).

### (Alicyclic diol)

Bifunctional polyol compounds such as hydrogenated bisphenol A, cyclobutanediol, cyclopentanediol, cyclohexanediol, cycloheptanediol, cyclooctanediol, cyclohexanedimethanol, hydroxypropylcyclohexanol, tricyclo[5,2,1,02,6]decane-dimethanol, bicyclo[4,3,0]-nonanediol, dicyclohexanediol, tricyclo[5,3,1,13,9]dodecanediol, bicyclo[4,3,0]nonanedimethanol, tricyclo[5,3,1,13,9]dodecane-diethanol, hydroxypropyltricyclo[5,3,1,13,9]dodecanol, spiro[3,4]octanediol, butylcyclohexanediol, 1,1'-bicyclohexylidenediol, 1,4-cyclohexanedimethanol, 1,3-cyclohexanedimethanol, 1,2-cyclohexanedimethanol, and o-dihydroxyxylylene.

### (Aromatic diol)

Bifunctional polyol compounds such as dihydroxynaphthalene, dihydroxybenzene, bisphenol A, bisphenol F, xylylene glycol, tetrabromobisphenol A, bis(4-hydroxyphenyl)methane, 1,1-bis(4-hydroxyphenyl)ethane, 1,2-bis(4-hydroxyphenyl)ethane, bis(4-hydroxyphenyl)phenylmethane, bis(4-hydroxyphenyl)diphenylmethane, bis(4-hydroxyphenyl)-1-naphthylmethane, 1,1-bis(4-hydroxyphenyl)-1-phenylethane, 2-(4-hydroxyphenyl)-2-(3-hydroxyphenyl) propane, 2,2-bis(4-hydroxyphenyl)butane, 1,1-bis(4-hydroxyphenyl)butane, 2,2-bis(4-hydroxyphenyl)-3-methylbutane, 2,2-bis(4-hydroxyphenyl)pentane, 3,3-bis(4-hydroxyphenyl)pentane, 2,2-bis(4-hydroxyphenyl)hexane, 2,2-bis(4-hydroxyphenyl)octane, 2,2-bis(4-hydroxyphenyl)-4-methylpentane, 2,2-bis(4-hydroxyphenyl)heptane, 4,4-bis(4-hydroxyphenyl)heptane, 2,2-bis(4-hydroxyphenyl)tridecane, 2,2-bis(4-hydroxyphenyl)octane, 2,2-bis(3-methyl-4-hydroxyphenyl)propane, 2,2-bis(3-ethyl-4-hydroxyphenyl)propane, 2,2-bis(3-n-propyl-4-hydroxyphenyl)propane, 2,2-bis(3-isopropyl-4-hydroxyphenyl)propane, 2,2-bis(3-sec-butyl-4-hydroxyphenyl)propane, 2,2-bis(3-tert-butyl-4-hydroxyphenyl)propane, 2,2-bis(3-cyclohexyl-4-hydroxyphenyl)propane, 2,2-bis(3-allyl-4'-hydroxyphenyl)propane, 2,2-bis(3-methoxy-4-hydroxyphenyl)propane, 2,2-bis(3,5-dimethyl-4-hydroxyphenyl)propane, 2,2-bis(2,3,5,6-tetramethyl-4-hydroxyphenyl)propane, bis(4-hydroxyphenyl)cyanomethane, 1-cyano-3,3-bis(4-hydroxyphenyl)butane, 2,2-bis(4-hydroxyphenyl)hexafluoropropane, 1,1-bis(4-hydroxyphenyl)cyclopentane, 1,1-bis(4-hydroxyphenyl)cyclohexane, 1,1-bis(4-hydroxyphenyl)cycloheptane, 1,1-bis(3-methyl-4-hydroxyphenyl)cyclohexane, 1,1-bis(3,5-dimethyl-4-hydroxyphenyl)cyclohexane, 1,1-bis(3,5-dichloro-4-hydroxyphenyl)cyclohexane, 1,1-bis(3-methyl-4-hydroxyphenyl)-4-methylcyclohexane, 1,1-bis(4-hydroxyphenyl)-3,3,5-trimethylcyclohexane, 2,2-bis(4-hydroxyphenyl)norbornane, 2,2-bis(4-hydroxyphenyl)adamantane, 4,4'-dihydroxydiphenyl ether, 4,4'-dihydroxy-3,3'-dimethyldiphenyl ether, ethylene glycol bis(4-hydroxyphenyl) ether, 4,4'-dihydroxydiphenyl sulfide, 3,3'-dimethyl-4,4'-dihydroxydiphenyl sulfide, 3,3'-dicyclohexyl-4,4'-dihydroxydiphenyl sulfide, 3,3'-diphenyl-4,4'-dihydroxydiphenyl sulfide, 4,4'-dihydroxydiphenyl sulfoxide, 3,3'-dimethyl-4,4'-dihydroxydiphenyl sulfoxide, 4,4'-dihydroxydiphenyl sulfone, 4,4'-dihydroxy-3,3'-dimethyldiphenyl sulfone, bis(4-hydroxyphenyl)ketone, bis(4-hydroxy-3-methylphenyl)ketone, 7,7'-dihydroxy-3,3',4,4'-tetrahydro-4,4,4',4',-tetramethyl-2,2'-spirobi(2H- 1-benzopyran), trans-2,3-bis(4-hydroxyphenyl)-2-butene, 9,9-bis(4-hydroxyphenyl)fluorene, 3,3-bis(4-hydroxyphenyl)-2-butanone, 1,6-bis(4-hydroxyphenyl)-1,6-hexanedione, 4,4'-dihydroxybiphenyl, m-dihydroxyxylylene, p-dihydroxyxylylene, 1,4-bis(2-hydroxyethyl)benzene, 1,4-bis(3-hydroxypropyl)benzene, 1,4-bis(4-hydroxybutyl)benzene, 1,4-bis(5-hydroxypentyl)benzene, 1,4-bis(6-hydroxyhexyl)benzene, 2,2-bis[4-(2"-hydroxyethyloxy)phenyl]propane, hydroquinone, and resorcin.

### (Polyester diol)

Examples thereof include a bifunctional polyol compound obtained by a condensation reaction of a polyol with a polybasic acid. Among these, the number average molecular weight is preferably 400 to 2,000, more preferably 500 to 1,500, and most preferably 600 to 1,200.

### (Polyether diol)

Examples thereof include a bifunctional polyol compound obtained by ring-opening polymerization of alkylene oxides or a reaction of a compound containing two or more active hydrogen-containing groups in a molecule with an alkylene oxide, and modified products thereof. Among these, the number average molecular weight is preferably 400 to 2,000, more preferably 500 to 1,500, and most preferably 600 to 1,200.

### (Polycaprolactone diol)

Examples thereof include a bifunctional polyol compound obtained by ring-opening polymerization of ε-caprolactone. Among these, the number average molecular weight is preferably 400 to 2,000, more preferably 500 to 1,500, and most preferably 600 to 1,200.

### (Polycarbonate diol)

Examples thereof include a bifunctional polyol compound obtained by phosgenation of one or more types of low molecular weight polyols, or a bifunctional polyol compound obtained by transesterification using ethylene carbonate, diethyl carbonate, diphenyl carbonate, and the like. Among these, the number average molecular weight is preferably 400 to 2,000, more preferably 500 to 1,500, and most preferably 600 to 1,200.

### (Dithiol)

Bifunctional polythiol compounds such as tetraethylene glycol bis(3-mercaptopropionate), 1,4-butanediol bis(3-mercaptopropionate), 1,6-hexanediol bis(3-mercaptopropionate), and 1,4-bis(mercaptopropylthiomethyl)benzene.

### (Compound containing both hydroxy group and thiol group)

Bifunctional poly(thi)ol compounds such as 2-mercaptoethanol, 1-hydroxy-4-mercaptocyclohexane, 2-mercaptohydroquinone, 4-mercaptophenol, 1-hydroxyethylthio-3-mercaptoethylthiobenzene, 4-hydroxy-4'-mercaptodiphenylsulfone, 2-(2-mercaptoethylthio)ethanol, dihydroxyethyl sulfide mono(3-mercaptopropionate), and dimercaptoethane mono(salicylate).

### (Bifunctional amine compound (A31))

Examples of the bifunctional amine compound (A31) include the following.

### (Aliphatic diamine)

Bifunctional amine compounds such as ethylenediamine, hexamethylenediamine, nonamethylenediamine, undecanemethylenediamine, dodecamethylenediamine, metaxylenediamine, 1,3-propanediamine, and putrescine.

### (Alicyclic diamine)

Bifunctional amine compounds such as isophoronediamine and cyclohexyldiamine.

### (Aromatic diamine)

Bifunctional amine compounds such as 4,4'-methylene bis(o-chloroaniline) (MOCA), 2,6-dichloro-p-phenylenediamine, 4,4'-methylene bis(2,3-dichloroaniline), 4,4'-methylene bis(2-ethyl-6-methylaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethylene glycol-di-p-aminobenzoate, polytetramethylene glycol-di-p-aminobenzoate, 4,4'-diamino-3,3',5,5'-tetraethyldiphenylmethane, 4,4'-diamino-3,3'-diisopropyl-5,5'-dimethyldiphenylmethane, 4,4'-diamino-3,3',5,5'-tetraisopropyldiphenylmethane, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 3,3'-diethyl-4,4'-diaminodiphenylmethane, m-xylylenediamine, N,N'-di-sec-butyl-p-phenylenediamine, m-phenylenediamine, p-xylylenediamine, p-phenylenediamine, 3,3'-methylenebis(methyl-6-aminobenzoate), 2-methylpropyl 2,4-diamino-4-chlorobenzoate, isopropyl 2,4-diamino-4-chlorobenzoate, isopropyl 2,4-diamino-4-chlorophenylacetate, di-(2-aminophenyl)thioethyl terephthalate, diphenylmethanediamine, tolylenediamine, and piperazine.

### (Method for preparing urethane prepolymer (A12))

The urethane prepolymer (A12) is prepared by reacting the bifunctional iso(thio)cyanate compound with the bifunctional poly(thi)ol compound (A21) and/or the bifunctional amine compound (A31). In the present invention, the urethane prepolymer (A12) must contain an unreacted iso(thio)cyanate group. A method for preparing the urethane prepolymer (A12) containing an iso(thio)cyanate group is not particularly limited to a known method, and examples thereof include a method for preparing a urethane prepolymer in a range in which the number of moles (n5) of an iso(thio)cyanate group in the bifunctional iso(thio)cyanate compound and the number of moles (n6) of an active hydrogen-containing group in the bifunctional poly(thi)ol compound (A21) and/or the bifunctional amine compound (A31) are 1 < (n5)/(n6) ≤ 2.3. When two or more types of bifunctional iso(thio)cyanate compounds are used, the number of moles (n5) of the iso(thio)cyanate group is the total number of moles of the iso(thio)cyanate groups in these bifunctional iso(thio)cyanate compounds. In addition, when two or more types of the bifunctional poly(thi)ol compounds (A21) and/or two or more types of the bifunctional amine compounds (A31) are used, the number of moles (n6) of the active hydrogen-containing group is the total number of moles of the active hydrogen in the bifunctional poly(thi)ol compounds (A21) and/or the bifunctional amine compounds (A31). In the present invention, even when the active hydrogen is a primary amino group, the primary amino group is calculated as 1 mol. The reason is that considerable energy is required for a reaction of a second amino group (-NH) in the primary amino group (the second -NH is less likely to react even in the primary amino group), and thus, in the present invention, even when a bifunctional active hydrogen-containing compound containing a primary amino group is used, the primary amino group is calculated as 1 mol.

Although not particularly limited, an iso(thio)cyanate equivalent of the urethane prepolymer (A12) (value obtained by dividing a molecular weight of the urethane prepolymer (A12) by the number of iso(thio)cyanate groups in one molecule) is preferably 300 to 5,000, more preferably 350 to 3,000, and particularly preferably 400 to 2,000. In addition, the urethane prepolymer (A12) in the present invention is preferably a linear urethane prepolymer prepared from the bifunctional iso(thio)cyanate compound, the bifunctional poly(thi)ol compound (A21) and/or the bifunctional amine compound (A31). In this case, both terminals are iso(thio)cyanate groups, and the number of iso(thio)cyanate groups in one molecule is 2.

The iso(thio)cyanate equivalent of the urethane prepolymer (A12) can be quantified by using the back titration method in accordance with JIS K 7301 that is described with respect to the isocyanate group contained in the urethane prepolymer (A12) or a back titration method in accordance with a method described in WO 2018-092826.

An iso(thio)cyanate content ((I), molar concentration by mass (mol/kg)) in the urethane prepolymer (A12) and a urethane bond content ((U), molar concentration by mass (mol/kg)) present in the urethane prepolymer (A12) are preferably 1 ≤ (U)/(I) ≤ 10. This range is the same when the urethane prepolymer (A12) and the bifunctional iso(thio)cyanate compound are used in combination.

The iso(thio)cyanate content ((I), molar concentration by mass (mol/kg)) is a value obtained by multiplying a reciprocal of the iso(thio)cyanate equivalent by 1,000. In addition, a theoretical value of the urethane bond content ((U), molar concentration by mass (mol/kg)) present in the urethane prepolymer (A12) is determined by the following method. That is, when a content of the iso(thio)cyanate group before the reaction present in the bifunctional iso(thio)cyanate compound forming the urethane prepolymer (A12) is defined as a total content of the iso(thio)cyanate group ((aI), molar concentration by mass (mol/kg)), the urethane bond content ((U), molar concentration by mass (mol/kg)) is a value ((U) = (aI) - (I)) obtained by subtracting the iso(thio)cyanate content ((I), molar concentration by mass (mol/kg)) from the total content of the iso(thio)cyanate group ((aI), molar concentration by mass (mol/kg)) in the component (A1), that is the urethane bond content (U) present in the urethane prepolymer (A12).

In the preparation of the urethane prepolymer (A12), it is also possible to perform heating or add a urethane catalyst as necessary. Any appropriate urethane catalyst may be used, and a urethane catalyst to be described later may be used as a specific example.

From the viewpoint of strength of the microballoon to be formed and control of the reactivity, most preferred examples as the component (A1) used in the present invention include alicyclic isocyanates such as isophorone diisocyanate, 1,3-bis(isocyanatemethyl)cyclohexane, and (bicyclo[2.2.1]heptane-2,5-(2,6)-diyl)bismethylene diisocyanate, aromatic isocyanates such as 2,4-tolylene diisocyanate, 2,6-tolylene diisocyanate, 4,4'-diphenylmethane diisocyanate, and xylylene diisocyanate (o-, m-, p-), polyfunctional isocyanates having a biuret structure, a uretdione structure, and an isocyanurate structure containing diisocyanates such as hexamethylene diisocyanate and tolylene diisocyanate as main raw materials, polyfunctional isocyanates as adducts with a polyol containing three or more functional groups, or the urethane prepolymer (A12).

### <Poly(thi)ol compound containing, in at least one molecule, two or more groups selected from group consisting of hydroxy group and thiol group (A2)>

The poly(thi)ol compound (A2) to be used in the present invention can be used without any limitation as long as the poly(thi)ol compound (A2) is a compound containing, in one molecule, two or more groups selected from the group consisting of a hydroxy group and a thiol group. Of course, a compound containing two groups, i.e., a hydroxy group and a thiol group, may also be selected. These compounds also include the bifunctional poly(thi)ol compound (A21) used for the preparation of the urethane prepolymer (A12). The component (A2) is suitably used in a microballoon formed of a urethane (urea) resin. The component (A2) to be particularly suitably used in the microballoon according to the present invention is a water-soluble poly(thi)ol compound.

In the present invention, the water-soluble poly(thi)ol compound is a compound that is at least partially soluble in water and that has an affinity with a hydrophilic phase greater than with a hydrophobic phase. In general, a water-soluble compound having a solubility of at least 1 g/l in a hydrophilic solvent such as water at room temperature may be selected, and a water-soluble compound having a solubility of 20 g/l or more in a hydrophilic solvent at room temperature is preferably used.

Examples of the water-soluble poly(thi)ol compound include bifunctional poly(thi)ols such as ethylene glycol, diethylene glycol, triethylene glycol, polyethylene glycol, propylene glycol, dipropylene glycol, tripropylene glycol, polypropylene glycol, neopentyl glycol, trimethylene glycol, 1,2-butanediol, 1,3-butanediol, 2,3-butanediol, 1,4-butanediol, 1,5-pentanediol, hexylene glycol, 1,6-hexanediol, 2-butene-1,4-diol, and 2-mercaptoethanol, trifunctional poly(thi)ols such as glycerin, trimethylolethane, trimethylolpropane, and 3-mercapto-1,2-propanediol, tetrafunctional polyols such as pentaerythritol, erythritol, diglycerol, diglycerin, and ditrimethylol propane, pentafunctional polyols such as arabitol, hexafunctional polyols such as dulcitol, sorbitol, mannitol, dipentaerythritol, or triglycerol, heptafunctional polyols such as volemitol, nonafunctional polyols such as isomalt, maltitol, isomaltitol, or lactitol, cellulose compounds (for example, methyl cellulose, ethyl cellulose, hydroxyethyl cellulose, ethylhydroxyethyl cellulose, carboxymethyl cellulose, hydroxypropyl cellulose, and saponified products thereof, and water-soluble polymers such as starch, dextrin, cyclic dextrin, chitin, a polyvinyl alcohol, and polyglycerin.

### <Polyfunctional amine compound containing at least two amino groups (A3)>

The polyfunctional amine compound (A3) to be used in the present invention can be used without any limitation as long as the polyfunctional amine compound (A3) is a monomer containing two or more amino groups in one molecule. These polyfunctional amine compounds (A3) also include the bifunctional amine compound (A31) used for the preparation of the urethane prepolymer (A12). The component (A3) is suitably used in a microballoon formed of a urethane (urea) resin or an amide resin. The component (A3) to be particularly suitably used in the microballoon of the present invention is a water-soluble polyamine compound.

A preferred solubility of the water-soluble polyamine compounds is the same as that of the water-soluble polyol compound. The water-soluble polyamine compound is a polyfunctional amine containing two or more amino groups in a molecule, and specific examples thereof include ethylenediamine, propylenediamine, 1,4-diaminobutane, hexamethylenediamine, 1,8-diaminooctane, 1,10-diaminodecane, dipropylenetriamine, bishexamethylenetriamine, tris(2-aminoethyl)amine, tris(3-aminopropyl)amine, 3,3',3"-nitrilotris(propionamide), piperazine, 2-methylpiperazine, isophoronediamine, diethylenetriamine, triethylenetetramine, tetraethylenepentamine, hydrazine, polyethyleneimines, and polyoxyalkyleneamines.

### <Compound containing at least both hydroxy group and amino group (A4)>

The compound containing at least both a hydroxy group and an amine group to be used in the present invention can be used without any limitation as long as the compound contains at least one or more hydroxy groups and one or more amino groups in a molecule. The component (A4) is suitably used in a microballoon formed of a urethane (urea) resin. The component (A4) to be particularly suitably used is a compound containing both a hydroxy group and an amino group in a water-soluble molecule.

A preferred solubility of the compound containing both a hydroxy group and an amino group in a water-soluble molecule is the same as that of the water-soluble polyol compound. Specific examples of the compound containing both a hydroxy group and an amino group in a water-soluble molecule include hydroxylamine, monoethanolamine, 3-amino-1-propanol, 2-amino-2-hydroxmethylpropane-1,3-diol, 2-hydroxyethylethylenediamine, 2-hydroxyethylpropylenediamine, N,N-bis(2-hydroxyethyl)ethylenediamine, N,N-bis(2-hydroxypropyl)ethylenediamine, N,N-bis(2-hydroxypropyl)propylenediamine, N-methylethanolamine, diethanolamine, and chitosan.

In the present invention, in order to facilitate introduction of the polymerizable functional group having reactivity with an iso(thio)cyanate group in a surface layer, among the components (A2) to (A4), a compound which is selected from the components (A2) to (A4) and in which a total amount of functional groups of a hydroxy group, a thiol group, and an amino group is three or more is preferred. When a compound containing 3 or more functional groups is used, some of the polymerizable functional groups are likely to remain on the surface layer.

Specific examples of a preferred compound containing three or more functional groups include glycerin, trimethylolethane, trimethylolpropane, pentaerythritol, erythritol, diglycerol, diglycerin, ditrimethylol propane, arabitol, sorbitol, mannitol, dipentaerythritol, or triglycerol, volemitol, isomalt, maltitol, isomaltitol, lactitol, cellulose compounds, starch, dextrin, cyclic dextrin, a polyvinyl alcohol, polyglycerin, tris(2-aminoethyl)amine, tris(3-aminopropyl)amine, 3,3',3"-nitrilotris(propionamide), polyethyleneimines, 2-amino-2-hydroxmethylpropane-1,3-diol, N,N-bis(2-hydroxyethyl)ethylenediamine, N,N-bis(2-hydroxypropyl)ethylenediamine, and N,N-bis(2-hydroxypropyl)propylenediamine.

### <Melamine formaldehyde prepolymer compound (A5)>

The melamine formaldehyde prepolymer compound (A5) is a melamine-formaldehyde precondensate of melamine and formaldehyde, and can be prepared according to a common method. Examples of the melamine-formaldehyde precondensate of melamine and formaldehyde include methylol melamine. In addition, as the melamine formaldehyde prepolymer compound, commercially available products also can be used as appropriate. Examples thereof include Beckamine APM, Beckamine M-3, Beckamine M-3 (60), Beckamine MA-S, Beckamine J-101, and Beckamine J-101LF (manufactured by DIC Corporation), Nikaresin S-176 and Nikaresin S-260 (manufactured by Nippon Carbide Industries Co., Inc.), and Mirben resin SM-800 (manufactured by Showa Highpolymer Co., Ltd.)

The component (A5) is suitably used in a microballoon formed of a melamine resin.

### <Urea formaldehyde prepolymer compound (A6)>

The urea formaldehyde prepolymer compound (A6) is a urea-formaldehyde precondensate of urea and formaldehyde, and can be prepared according to a common method. Examples of the urea-formaldehyde precondensate of urea and formaldehyde include methylol urea. In addition, as the urea formaldehyde prepolymer compound, commercially available products can also be used as appropriate. Examples thereof include 8HSP (manufactured by Showa Highpolymer Co., Ltd.).

The component (A6) is suitably used in a microballoon formed of a urea resin.

### <Polyfunctional carboxylic acid compound containing at least two carboxy groups - component (A7)>

Examples of the polyfunctional carboxylic acid compound (A7) include a dicarboxylic acid compound and a dicarboxylic acid dihalide.

Examples of the dicarboxylic acid compound include alkenylene dicarboxylic acids such as succinic acid, adipic acid, sebacic acid, dodecenylsuccinic acid, azelaic acid, sebacic acid, dodecanedicarboxylic acid, octadecanedicarboxylic acid, dodecenylsuccinic acid, pentadecenylsuccinic acid, octadecenylsuccinic acid, maleic acid, and fumaric acid, decylsuccinic acid, dodecylsuccinic acid, octadecylsuccinic acid, phthalic acid, isophthalic acid, terephthalic acid, and naphthalenedicarboxylic acid.

Examples of the dicarboxylic acid dihalide include an aliphatic dicarboxylic acid dihalide, an alicyclic dicarboxylic acid dihalide, and an aromatic dicarboxylic acid dihalide.

Examples of the aliphatic dicarboxylic acid dihalide include oxalic acid dichloride, malonic acid dichloride, succinic acid dichloride, fumaric acid dichloride, glutaric acid dichloride, adipic acid dichloride, muconic acid dichloride, sebacic acid dichloride, nonanoic acid dichloride, undecanoic acid dichloride, oxalic acid dibromide, malonic acid dibromide, succinic acid dibromide, and fumaric acid dibromide.

Examples of the alicyclic dicarboxylic acid dihalide include 1,2-cyclopropanedicarboxylic acid dichloride, 1,3-cyclobutanedicarboxylic acid dichloride, 1,3-cyclopentanedicarboxylic acid dichloride, 1,3-cyclohexanedicarboxylic acid dichloride, 1,4-cyclohexanedicarboxylic acid dichloride, 1,3-cyclopentanedicarboxylic acid dichloride, 1,2-cyclopropanedicarboxylic acid dibromide, and 1,3-cyclobutanedicarboxylic acid dibromide.

Examples of the aromatic dicarboxylic acid dihalide include phthalic acid dichloride, isophthalic acid dichloride, terephthalic acid dichloride, 1,4-naphthalenedicarboxylic acid dichloride, 1,5-(9-oxofluorene)dicarboxylic acid dichloride, 1,4-anthracenedicarboxylic acid dichloride, 1,4-anthraquinonedicarboxylic acid dichloride, 2,5-biphenyldicarboxylic acid dichloride, 1,5-biphenylenedicarboxylic acid dichloride, 4,4'-biphenyldicarbonyl chloride, 4,4'-methylene dibenzoic acid dichloride, 4,4'-isopropylidene dibenzoic acid dichloride, 4,4'-bibenzyldicarboxylic acid dichloride, 4,4'-stilbenedicarboxylic acid dichloride, 4,4'-trans dicarboxylic acid dichloride, 4,4'-carbonyl dibenzoic acid dichloride, 4,4'-oxydibenzoic acid dichloride, 4,4'-sulfonyl dibenzoic acid dichloride, 4,4'-dithiodibenzoic acid dichloride, p-phenylene diacetic acid dichloride, 3,3'-p-phenylenedipropionic acid dichloride, phthalic acid dibromide, isophthalic acid dibromide, and terephthalic acid dibromide.

In the present invention, preferred examples of the component (A7) include a dicarboxylic acid dihalide from the viewpoint of a polymerization rate.

### <Method of preparing microballoon>

As a method of preparing the microballoon according to the present invention, a known method can be used without limitation, for example, a microballoon may be prepared using a known method using an emulsion made of an aqueous phase and an oil phase, such as interfacial polymerization, coacervation method, and In-situ polymerization. In addition, as necessary, a hollow microballoon can be prepared by removing a liquid inside.

It is preferred that the microballoon according to the present invention is formed of at least one resin selected from the group consisting of a urethane (urea) resin, a melamine resin, a urea resin, and an amide resin. When the microballoon is formed of these resins, not only excellent characteristics but also excellent polishing characteristics can be exhibited when the microballoon is used in a CMP polishing pad.

Specifically, the microballoon according to the present invention can be prepared by, for example, the following method, but the present invention is not limited to the following method.

### <The case where microballoon is formed of urethane (urea) resin or amide resin>

When the microballoon according to the present invention is formed of a urethane (urea) resin or an amide resin, the microballoon can be prepared by interfacial polymerization. In the interfacial polymerization, after an oil-in-water (O/W) emulsion (hereinafter, also referred to as an O/W emulsion) or a water-in-oil (W/O) emulsion (hereinafter, also referred to as a W/O emulsion) is prepared, a microballoon can be prepared by interfacial polymerization. In the present invention, any one of the O/W emulsion and the W/O emulsion can be selected, and interfacial polymerization in the O/W emulsion is preferred because a microballoon containing, in a surface layer of the microballoon, a polymerizable functional group having reactivity with an iso(thio)cyanate group can be efficiently prepared by the interfacial polymerization in the O/W emulsion. An interfacial polymerization method in an O/W emulsion will be described below. The following example is, in principle, an example of a urethane (urea) resin, and an amide resin is noted as "a case of being formed of an amide resin".

When the polymerization method in the O/W emulsion is subdivided, the polymerization method is divided into a first step of preparing (a) an oil phase containing at least the component (A1) (component (A7) in the case of being formed of an amide resin) and an organic solvent (hereinafter, also referred to as a component (a)), a second step of preparing (b) an aqueous phase containing an emulsifier (hereinafter, also referred to as a component (b)), a third step of mixing and stirring the component (a) and the component (b) to prepare an O/W emulsion in which the aqueous phase is a continuous phase and the oil phase is a dispersed phase, a fourth step of obtaining a microballoon dispersion in which microballoons are dispersed by adding, to the O/W emulsion, a hydrophilic compound selected from the components (A2) to (A4) (components (A3) and (A4) in the case of being formed of an amide resin, here, the component (A4) "in the case of being formed of an amide resin" is limited to the component (A4) containing two or more amino groups, and the same applies hereinafter) and by proceeding interfacial polymerization in the O/W emulsion to form a resin membrane to form microballoons, and a fifth step of separating the microballoons from the microballoon dispersion. In the present invention, the polymerization method may further include a sixth step of removing an organic solvent solution from the inside of the microballoons.

### First step:

The first step is a step of preparing the oil phase (a) containing at least the component (A1) (component (A7) in the case of being formed of an amide resin) and the organic solvent, the oil phase (a) being a dispersed phase in the O/W emulsion.

The step is a step of dissolving the component (A1) (component (A7) in the case of being formed of an amide resin) in the organic solvent to be described later to form the oil phase, and the dissolution may be performed by using a known method to form a uniform solution.

When the microballoon according to the present invention is formed of a urethane (urea) resin, a preferred amount of the component (A1) to be used is 0.1 to 50 parts by mass, preferably 0.5 to 20 parts by mass, and more preferably 1 to 10 parts by mass with respect to 100 parts by mass of the organic solvent. Further, when the total number of moles of the hydroxy group, the thiol group, and the amino group in the components (A2) to (A4) is (n2) with respect to the number of moles (n1) of the isocyanate group contained in the component (A1), a range of 0.3 ≤ (n1)/(n2) ≤ 2.0 is preferred, a range of 0.3 ≤ (n1)/(n2) ≤ 1.0 is more preferred, and a range of 0.3 ≤ (n1)/(n2) ≤ 0.8 is most preferred.

When the microballoon according to the present invention is formed of an amide resin, a preferred amount of the component (A7) to be used is 0.1 to 50 parts by mass, preferably 0.5 to 20 parts by mass, and more preferably 1 to 10 parts by mass with respect to 100 parts by mass of the organic solvent. Further, when the total number of moles of the amino group and the hydroxy group in the components (A3) and (A4) is (n4) with respect to the number of moles (n3) of the carboxylic acid group contained in the component (A7), a range of 0.3 ≤ (n3)/(n4) ≤ 2.0 is preferred, in a range of 0.3 ≤ (n3)/(n4) ≤ 1.0 is more preferred, and a range of 0.3 ≤ (n3)/(n4) ≤ 0.8 is most preferred.

A catalyst to be described later may be added to the component (a) for a purpose of promoting the interfacial polymerization reaction.

### Second step:

The second step is a step of preparing the aqueous phase (b) containing an emulsifier and water, the aqueous phase (b) being a continuous phase in the O/W emulsion.

The step is a step of dissolving the emulsifier to be described later in water to form an aqueous phase, and the emulsifier may be dissolved by using a known method to form a uniform solution.

In the present invention, an amount of the emulsifier to be used is 0.01 to 20 parts by mass, and preferably 0.1 to 10 parts by mass, with respect to 100 parts by mass of water. Within this range, droplets of the dispersed phase in the O/W emulsion can be prevented from being aggregated, and microballoons having a uniform average particle diameter can be easily obtained.

A catalyst to be described later may be added to the component (b) for a purpose of promoting the interfacial polymerization reaction.

### Third step:

The third step is a step of mixing and stirring the component (a) obtained in the first step and the component (b) obtained in the second step to prepare the O/W emulsion in which the component (a) is a dispersed phase and the component (b) is a continuous phase.

In the present invention, in the method for preparing the O/W emulsion by mixing and stirring the component (a) and the component (b), the O/W emulsion can be prepared by appropriately mixing and stirring the component (a) and the component (b) according to a known method in consideration of particle diameters of microballoons to be prepared.

Among these, a method for preparing an O/W emulsion is suitably a method of mixing the component (a) and the component (b) and then, for stirring, dispersing the mixture using a known disperser such as a high-speed shearing type disperser, a friction type disperser, a high-pressure jet type disperser, and an ultrasonic type disperser, and among these, a high-speed shearing type disperser is preferred. When the high-speed shearing type disperser is used, a rotation number is preferably 500 rpm to 20,000 rpm, and more preferably 1,000 rpm to 10,000 rpm. A dispersion time is preferably 0.1 minutes to 60 minutes, and more preferably 0.5 minutes to 30 minutes. A dispersion temperature is preferably 10°C to 40°C.

In the present invention, regarding a weight ratio of the component (a) to the component (b), it is preferred that, when an amount of the component (b) is 100 parts by mass, an amount of the component (a) is preferably 1 to 100 parts by mass, more preferably 2 to 90 parts by mass, and most preferably 5 to 50 parts by mass. Within this range, a good emulsion can be obtained.

### Fourth step:

The fourth step is a step of obtaining a microballoon dispersion in which the microballoons are dispersed by adding, to the O/W emulsion, at least one compound selected from the components (A2) to (A4) (components (A3) and (A4) in the case of being formed of an amide resin) and by proceeding interfacial polymerization in the O/W emulsion to form a resin film to form microballoons.

When the components (A2) to (A4) (components (A3) and (A4) in the case of being formed of an amide resin) are added to the O/W emulsion, the components (A2) to (A4) may be added as it is, or may be used by being dissolved in water in advance.

When the components (A2) to (A4) are dissolved in water in advance, water is suitably used in a range of 50 to 10,000 parts by mass when a total amount of the components (A2) to (A4) (components (A3) and (A4) in the case of being formed of an amide resin) is 100 parts by mass.

A reaction temperature is not particularly limited as long as it is a temperature at which the O/W emulsion is not damaged, and it is preferred to perform the reaction at a preferred reaction temperature in a range of 5°C to 70°C. A reaction time is also not particularly limited as long as the W/O emulsion can be formed, and is usually selected from a range of 0.5 hours to 24 hours.

### Fifth step:

The fifth step is a step of separating the microballoons from the microballoon dispersion. A method for separating microballoons from a microballoon dispersion is not particularly limited and may be selected from general separation methods, and specifically, filtration or centrifugation is used.

### Sixth step:

The sixth step is a step of removing an internal oil phase from the microballoons obtained in the fifth step to form hollow microballoons. A method of removing an oil phase from microballoons is not particularly limited and may be selected from general separation methods, and specifically, an air-circulating dryer, a spray dryer, a fluidized bed dryer, a vacuum dryer, and the like may be used. A temperature during the drying is preferably 40°C to 250°C, and more preferably 50°C to 200°C.

### <The case where microballoon is formed of melamine resin or urea resin>

When the microballoon according to the present invention is formed of a melamine resin or a urea resin, the microballoon can also be prepared by interfacial polymerization or In-situ polymerization after forming an O/W emulsion. Specific examples are shown below, but the preparation method in the present invention is not limited thereto.

When a polymerization method in an O/W emulsion in a case in which the microballoon is formed of a melamine resin or a urea resin is subdivided, the polymerization method is divided into a first step of preparing (c) an oil phase containing an organic solvent (hereinafter, also referred to as a component (c)), a second step of preparing (d) an aqueous phase containing an emulsifier (hereinafter, also referred to as a component (d)), a third step of mixing and stirring the component (c) and the component (d) to prepare an O/W emulsion in which the aqueous phase is a continuous phase and the oil phase is a dispersed phase, a fourth step of obtaining a microballoon dispersion in which microballoons are dispersed by adding the component (A5) or the component (A6) to the O/W emulsion and by proceeding interfacial polymerization in the O/W emulsion to form a resin phase, and a fifth step of separating the microballoons from the microballoon dispersion. In the present invention, the polymerization method may further include a sixth step of removing an organic solvent solution from the inside of the microballoons.

### First step:

The first step is a step of preparing the oil phase (c) containing an organic solvent, the oil phase (c) being a dispersed phase in the O/W emulsion.

In this step, the organic solvent may be prepared.

### Second step:

The second step is a step of preparing the aqueous phase (d) containing an emulsifier and water, and adjusting pH, the aqueous phase (d) being a continuous phase in the O/W emulsion.

The step includes a step of dissolving the emulsifier to be described later into water and adjusting pH. The adjustment of pH or the like may be performed by using a known method.

In the present invention, the amount of the emulsifier to be used is 0.01 to 20 parts by mass, and preferably 0.1 to 10 parts by mass, with respect to 100 parts by mass of water. Within this range, droplets of the dispersed phase in the O/W emulsion can be prevented from being aggregated, and microballoons having a uniform average particle diameter can be easily obtained.

The pH is preferably adjusted to less than 7, more preferably 3.5 to 6.5, and most preferably 4.0 to 5.5. By setting the pH range, the polymerization of the component (A5) or the component (A6), which will be described later, can proceed. Third step:

The third step is a step of mixing and stirring the component (c) obtained in the first step and the component (d) obtained in the second step to prepare the O/W emulsion in which the component (c) is a dispersed phase and the component (d) is a continuous phase.

In the present invention, in the method for preparing the O/W emulsion by mixing and stirring the component (c) and the component (d), the O/W emulsion can be prepared by appropriately mixing and stirring the component (c) and the component (d) according to a known method in consideration of particle diameters of microballoons to be prepared. Further, in the step of preparing the O/W emulsion, a temperature and the pH can also be adjusted.

Among these, the method for preparing the O/W emulsion is suitably a method of mixing the component (c) and the component (d) and then, for stirring, dispersing the mixture using a known disperser such as a high-speed shearing type disperser, a friction type disperser, a high-pressure jet type disperser, and an ultrasonic type disperser, and among these, a high-speed shearing type disperser is preferred. When the high-speed shearing type disperser is used, a rotation number is preferably 500 rpm to 20,000 rpm, and more preferably 1,000 rpm to 10,000 rpm. A dispersion time is preferably 0.1 minutes to 60 minutes, and more preferably 0.5 minutes to 30 minutes. A dispersion temperature is preferably 20°C to 90°C.

In the present invention, regarding a weight ratio of the component (c) to the component (d), it is preferred that, when an amount of the component (d) is 100 parts by mass, an amount of the component (c) is preferably 1 to 100 parts by mass, more preferably 2 to 90 parts by mass, and most preferably 5 to 50 parts by mass. Within this range, a good emulsion can be obtained.

### Fourth step:

The fourth step is a step of obtaining a microballoon dispersion in which formed microballoons are dispersed by adding the component (A5) or the component (A6) to the O/W emulsion and by proceeding interfacial polymerization in the O/W emulsion to form a resin film to form microballoons.

An amount of the component (A5) or the component (A6) to be used is not particularly limited, and is preferably 0.5 to 50 parts by mass, and more preferably 1 to 20 parts by mass per 100 parts by mass of the organic solvent used in the first step, in order to form good microballoons.

When the component (A5) or the component (A6) is added to the O/W emulsion, the component (A5) or the component (A6) may be added as it is, or may be used by being dissolved in water.

When the component (A5) or the component (A6) is dissolved in water, water is suitably used in a range of 50 to 10,000 parts by mass when a total amount of the component (A5) or the component (A6) is 100 parts by mass.

The pH of the aqueous phase as the continuous phase may be adjusted in the second step, or may be adjusted after the component (A5) or the component (A6) is added in the fourth step. The pH of the aqueous phase as the continuous phase is preferably at least less than 7. It is preferred to perform a reaction at a preferred reaction temperature in a range of 40°C to 90°C. It is preferred to perform the reaction at a reaction time in a range of 1 hours to 48 hours.

### Fifth step and sixth step:

The fifth step and the sixth step are the same steps as in the case in which the microballoon is formed of a urethane (urea) resin (or a polyamide resin).

Hereinafter, components to be used in the present invention will be described.

### <Emulsifier>

In the present invention, the emulsifier to be used in the component (b) or the component (d) includes a dispersant, a surfactant, or a combination thereof.

Examples of the dispersant include a polyvinyl alcohol and modified products thereof (for example, an anion-modified polyvinyl alcohol), cellulose compounds (for example, methyl cellulose, ethyl cellulose, hydroxyethyl cellulose, ethylhydroxyethyl cellulose, carboxymethyl cellulose, hydroxypropyl cellulose, and saponified products thereof), polyacrylic acid amide and derivatives thereof, an ethylene-vinyl acetate copolymer, a styrene-maleic anhydride copolymer, an ethylene-maleic anhydride copolymer, an isobutylene-maleic anhydride copolymer, polyvinyl pyrrolidone, an ethylene-acrylic acid copolymer, a vinyl acetate-acrylic acid copolymer, sodium polyacrylate, potassium polyacrylate, ammonium polyacrylate, partially neutralized polyacrylic acid, a sodium acrylate-acrylate ester copolymer, carboxymethyl cellulose, casein, gelatin, dextrin, chitin, chitosan, starch derivatives, gum arabic, and sodium alginat.

It is preferred that these dispersants do not react with a polymerizable composition to be used in the present invention or are extremely less likely to react with the polymerizable composition. For example, it is preferred that those containing a reactive amino group in a molecular chain such as gelatin are subjected to a treatment of losing reactivity in advance.

Examples of the surfactant include an anionic surfactant, a cationic surfactant, an amphoteric surfactant, and a nonionic surfactant. Two or more types of surfactants may be used in combination.

Examples of the anionic surfactant include a carboxylic acid or a salt thereof, a sulfate ester salt, a carboxymethylated product salt, a sulfonic acid salt, and a phosphate ester salt.

Examples of the carboxylic acid or the salt thereof include a saturated or unsaturated fatty acid having 8 to 22 carbon atoms or a salt thereof, and specific examples thereof include capric acid, lauric acid, myristic acid, palmitic acid, stearic acid, arachidic acid, behenic acid, oleic acid, linoleic acid, ricinoleic acid, and a mixture of higher fatty acids obtained by saponifying coconut oil, palm kernel oil, rice bran oil, beef tallow, and the like. Examples of the salt include a sodium salt, a potassium salt, an ammonium salt, and an alkanolamine salt.

Examples of the sulfate ester salt include a higher alcohol sulfate ester salt (sulfate ester salt of an aliphatic alcohol having 8 to 18 carbon atoms), a higher alkyl ether sulfate ester salt (sulfate ester salt of an ethylene oxide adduct of an aliphatic alcohol having 8 to 18 carbon atoms), a sulfated oil (obtained by directly sulfating and neutralizing an unsaturated fatty oil or an unsaturated wax), a sulfated fatty acid ester (obtained by sulfating and neutralizing a lower alcohol ester of an unsaturated fatty acid), and a sulfated olefin (obtained by sulfating and neutralizing an olefin having 12 to 18 carbon atoms). Examples of the salt include a sodium salt, a potassium salt, an ammonium salt, and an alkanolamine salt.

Specific examples of the higher alcohol sulfate ester salt include an octyl alcohol sulfate ester salt, a decyl alcohol sulfate ester salt, a lauryl alcohol sulfate ester salt, a stearyl alcohol sulfate ester salt, and a sulfate ester salt of an alcohol (OXOCOL 900, i.e., tridecanol, manufactured by Kyowa Hakko Kogyo Co., Ltd.) synthesized by an oxo method.

Specific examples of the higher alkyl ether sulfate ester salt include a lauryl alcohol ethylene oxide 2 mol adduct sulfate ester salt and an octyl alcohol ethylene oxide 3 mol adduct sulfate ester salt.

Specific examples of the sulfated oil include a sodium salt, a potassium salt, an ammonium salt, and an alkanolamine salt of sulfated products of castor oil, peanut oil, olive oil, rapeseed oil, beef tallow, and mutton tallow.

Specific examples of the sulfated fatty acid ester include a sodium salt, a potassium salt, an ammonium salt, and an alkanolamine salt of sulfated products of butyl oleate and butyl ricinoleate.

Examples of the carboxymethylated product salt include a carboxymethylated product salt of an aliphatic alcohol having 8 to 16 carbon atoms and a carboxymethylated product salt of an ethylene oxide adduct of an aliphatic alcohol having 8 to 16 carbon atoms.

Specific examples of the carboxymethylated product salt of the aliphatic alcohol include an octyl alcohol carboxymethylated sodium salt, a decyl alcohol carboxymethylated sodium salt, a lauryl alcohol carboxymethylated sodium salt, and a tridecanol carboxymethylated sodium salt.

Specific examples of the carboxymethylated product salt of the ethylene oxide adduct of the aliphatic alcohol include an octyl alcohol ethylene oxide 3 mol adduct carboxymethylated sodium salt, a lauryl alcohol ethylene oxide 4 mol adduct carboxymethylated sodium salt, and a tridecanol ethylene oxide 5 mol adduct carboxymethylated sodium salt.

Examples of the sulfonic acid salt include an alkylbenzenesulfonic acid salt, an alkylnaphthalenesulfonic acid salt, a sulfosuccinic acid diester type, an α-olefinsulfonic acid salt, an igepon T type, and other sulfonic acid salts of aromatic ring-containing compounds.

Specific examples of the alkylbenzenesulfonic acid salt include a dodecylbenzenesulfonic acid sodium salt.

Specific examples of the alkylnaphthalenesulfonic acid salt include a dodecylbenzenesulfonic acid sodium salt.

Specific examples of the sulfosuccinic acid diester type include a sulfosuccinic acid di-2-ethylhexyl ester sodium salt.

Examples of the sulfonic acid salt of the aromatic ring-containing compound include a mono- or di-sulfonic acid salt of an alkylated diphenyl ether, and a styrenated phenolsulfonic acid salt.

Examples of the phosphate ester salt include a higher alcohol phosphate ester salt and a higher alcohol ethylene oxide adduct phosphate ester salt.

Specific examples of the higher alcohol phosphate ester salt include a lauryl alcohol phosphate monoester disodium salt and a lauryl alcohol phosphate diester sodium salt.

Specific examples of the higher alcohol ethylene oxide adduct phosphate ester salt include an oleyl alcohol ethylene oxide 5 mol adduct phosphate monoester disodium salt.

Examples of the cationic surfactant include a quaternary ammonium salt type and an amine salt type.

The quaternary ammonium salt type is obtained by a reaction of a tertiary amine with a quaternizing agent (alkylating agents such as methyl chloride, methyl bromide, ethyl chloride, benzyl chloride, and dimethyl sulfate, ethylene oxide, and the like), and examples thereof include lauryltrimethylammonium chloride, didecyldimethylammonium chloride, dioctyldimethylammonium bromide, stearyltrimethylammonium bromide, lauryldimethylbenzylammonium chloride (benzalkonium chloride), cetylpyridinium chloride, polyoxyethylenetrimethylammonium chloride, and stearamidoethyldiethylmethylammonium methosulfate.

The amine salt type is obtained by neutralizing primary amines to tertiary amines with inorganic acids (such as hydrochloric acid, nitric acid, sulfuric acid, and hydroiodic acid) or organic acids (such as acetic acid, formic acid, oxalic acid, lactic acid, gluconic acid, adipic acid, and alkyl phosphoric acid). Examples of a primary amine salt type include inorganic acid salts or organic acid salts of aliphatic higher amines (higher amines such as laurylamine, stearylamine, cetylamine, cured beef tallow amine, and rosinamine), and higher fatty acid (such as stearic acid and oleic acid) salts of lower amines.

Examples of a secondary amine salt type include inorganic acid salts or organic acid salts of ethylene oxide adducts of aliphatic amines.

Examples of a tertiary amine salt type include inorganic acid salts or organic acid salts of an aliphatic amine (such as triethylamine, ethyldimethylamine, and N,N,N',N'-tetramethylethylenediamine), an ethylene oxide adduct of an aliphatic amine, an alicyclic amine (such as N-methylpyrrolidine, N-methylpiperidine, N-methylhexamethyleneimine, N-methylmorpholine, and 1,8-diazabicyclo(5,4,0)-7-undecene), and a nitrogen-containing heterocyclic ring aromatic amine (such as 4-dimethylaminopyridine, N-methylimidazole, and 4,4'-dipyridyl), or inorganic acid salts or organic acid salts of tertiary amines such as triethanolamine monostearate and stearamidoethyldiethylmethylethanolamine.

Examples of the amphoteric surfactant include a carboxylic acid salt-type amphoteric surfactant, a sulfate ester salt-type amphoteric surfactant, a sulfonic acid salt-type amphoteric surfactant, and a phosphate ester salt-type amphoteric surfactant, and examples of the carboxylic acid salt-type amphoteric surfactant include an amino acid-type amphoteric surfactant and a betaine-type amphoteric surfactant.

Examples of the carboxylic acid salt-type amphoteric surfactant include an amino acid-type amphoteric surfactant, a betaine-type amphoteric surfactant, and an imidazoline-type amphoteric surfactant. Among these, the amino acid type-amphoteric surfactant is an amphoteric surfactant containing an amino group and a carboxy group in a molecule, and specific examples thereof include an alkylaminopropionic acid-type amphoteric surfactant (such as sodium stearylaminopropionate and sodium laurylaminopropionate) and an alkylaminoacetic acid-type amphoteric surfactant (such as sodium laurylaminoacetate).

The betaine-type amphoteric surfactant is an amphoteric surfactant containing a quaternary ammonium salt type cation moiety and a carboxylic acid type anion moiety in a molecule, and examples thereof include an alkyldimethyl betaine (such as betaine stearyldimethylaminoacetate and betaine lauryldimethylaminoacetate), an amide betaine (such as coconut oil fatty acid amidepropyl betaine), and an alkyldihydroxyalkyl betaine (such as lauryldihydroxyethyl betaine).

Further, examples of the imidazoline-type amphoteric surfactant include 2-undecyl-N-carboxymethyl-N-hydroxyethylimidazolinium betaine.

Examples of other amphoteric surfactants include glycine-type amphoteric surfactants such as sodium lauroyl glycine, sodium lauryl diaminoethyl glycine, lauryl diaminoethyl glycine hydrochloride salt, and dioctyl diaminoethyl glycine hydrochloride salt, and sulfobetaine-type amphoteric surfactants such as pentadecylsulfotaurine.

Examples of the nonionic surfactant include an alkylene oxide addition-type nonionic surfactant and a polyhydric alcohol-type nonionic surfactant.

The alkylene oxide addition-type nonionic surfactant is obtained by directly adding an alkylene oxide to a higher alcohol, a higher fatty acid, or an alkylamine or the like, or reacting a higher fatty acid or the like with polyalkylene glycols obtained by adding an alkylene oxide to glycols, or adding an alkylene oxide to an esterified product obtained by reacting a polyhydric alcohol with a higher fatty acid, or adding an alkylene oxide to a higher fatty acid amide.

Examples of the alkylene oxide include ethylene oxide, propylene oxide, and butylene oxide.

Specific examples of the alkylene oxide addition-type nonionic surfactant include an oxyalkylene alkyl ether (for example, an octyl alcohol ethylene oxide adduct, a lauryl alcohol ethylene oxide adduct, a stearyl alcohol ethylene oxide adduct, an oleyl alcohol ethylene oxide adduct, and a lauryl alcohol ethylene oxide propylene oxide block adduct), a polyoxyalkylene higher fatty acid ester (for example, a stearyl acid ethylene oxide adduct and a lauryl acid ethylene oxide adduct), a polyoxyalkylene polyhydric alcohol higher fatty acid ester (for example, a polyethylene glycol lauric acid diester, a polyethylene glycol oleic acid diester, and a polyethylene glycol stearic acid diester), a polyoxyalkylene alkylphenyl ether (for example, a nonylphenol ethylene oxide adduct, a nonylphenol ethylene oxide propylene oxide block adduct, an octylphenol ethylene oxide adduct, a bisphenol A ethylene oxide adduct, a dinonylphenol ethylene oxide adduct, and a styrenated phenol ethylene oxide adduct), a polyoxyalkylene alkylamino ether (for example, a laurylamine ethylene oxide adduct and a stearylamine ethylene oxide adduct), and a polyoxyalkylene alkylalkanolamide (for example, an ethylene oxide adduct of a hydroxyethyllauric acid amide, an ethylene oxide adduct of a hydroxypropyloleic acid amide, and an ethylene oxide adduct of a dihydroxyethyllauric acid amide).

Examples of the polyhydric alcohol-type nonionic surfactant include a polyhydric alcohol fatty acid ester, a polyhydric alcohol fatty acid ester alkylene oxide adduct, a polyhydric alcohol alkyl ether, and a polyhydric alcohol alkyl ether alkylene oxide adduct.

Specific examples of the polyhydric alcohol fatty acid ester include pentaerythritol monolaurate, pentaerythritol monooleate, sorbitan monolaurate, sorbitan monostearate, sorbitan monolaurate, sorbitan dilaurate, sorbitan dioleate, and sucrose monostearate.

Specific examples of the polyhydric alcohol fatty acid ester alkylene oxide adduct include an ethylene glycol monooleate ethylene oxide adduct, an ethylene glycol monostearate ethylene oxide adduct, a trimethylolpropane monostearate ethylene oxide propylene oxide random adduct, a sorbitan monolaurate ethylene oxide adduct, a sorbitan monostearate ethylene oxide adduct, a sorbitan distearate ethylene oxide adduct, and a sorbitan dilaurate ethylene oxide propylene oxide random adduct.

Specific examples of the polyhydric alcohol alkyl ether include pentaerythritol monobutyl ether, pentaerythritol monolauryl ether, sorbitan monomethyl ether, sorbitan monostearyl ether, methyl glycoside, and lauryl glycoside.

Specific examples of the polyhydric alcohol alkyl ether alkylene oxide adduct include a sorbitan monostearyl ether ethylene oxide adduct, a methyl glycoside ethylene oxide propylene oxide random adduct, a lauryl glycoside ethylene oxide adduct, and a stearyl glycoside ethylene oxide propylene oxide random adduct.

Among these, the emulsifier to be used in the present invention is preferably selected from the dispersants and the nonionic surfactants, and as specific examples of a still preferred emulsifier, a polyvinyl alcohol or an anion-modified polyvinyl alcohol is preferred when the microballoon according to the present invention is formed of a urethane (urea) resin, and a sodium acrylate-acrylate ester copolymer is preferred when the microballoon is formed of an amide resin. When the emulsifiers are selected, a stable emulsion can be obtained.

When the microballoon is formed of a melamine resin or a urea resin, the emulsifier is preferably a styrene-maleic anhydride copolymer, an ethylene-maleic anhydride copolymer, and an isobutylene-maleic anhydride copolymer. By neutralizing the emulsifiers with an alkaline compound such as sodium hydroxide, a high-density anionic polymer can be obtained, and a polymerization reaction of the component (A5) or the component (A6) can proceed.

### <Organic solvent>

In the present invention, the organic solvent to be used in the component (a) or the component (c) is not particularly limited as long as the component (A1), the component (A7), or a lipophilic component (A) is dissolved therein. In addition, in the present invention, the term "lipophilic" means that a solubility in water is 1 g/L or less. Examples of the organic solvent include hydrocarbon-based, halogenated-based, and ketone-based solvents.

Among these, when the organic solvent is removed from the inside of the microballoon to form a hollow microballoon, those having a boiling point of 200°C or lower are preferred, and those having a boiling point of 150°C or lower are more preferred. Examples of the organic solvents include the following.

### (Hydrocarbon-based)

Examples thereof include aromatic hydrocarbons such as n-hexane, n-heptane, n-octane, n-hexadecane, benzene, toluene, and xylene, and alicyclic hydrocarbons such as cyclohexane, cyclopentane, and methylcyclohexane.

### (Halogenated-based)

Examples thereof include chloroform, dichloromethane, tetrachloroethane, and mono- or di-chlorobenzene.

### (Ketone-based)

Examples thereof include methyl isobutyl ketone.

These organic solvents may be used alone or in combination of two or more thereof.

Among these, the organic solvent to be used in the present invention is more preferably n-hexane, n-heptane, n-octane, benzene, toluene, xylene, and the like.

### <Additive>

In the present invention, in order to further stabilize the emulsion, an additive may be added to the aqueous phase as long as the effects of the present invention are not impaired. Examples of such an additive include water-soluble salts such as sodium carbonate, calcium carbonate, potassium carbonate, sodium phosphate, potassium phosphate, calcium phosphate, sodium chloride, and potassium chloride. These additives may be used alone or in combination of two or more thereof.

### <Catalyst>

### (Urethane catalyst)

In the present invention, any appropriate urethane catalyst to be used in a case in which the urethane prepolymer, that is, the component (A12) is synthesized or in a case in which the microballoon is formed of a urethane (urea) resin can be used without any limitation. Specific examples thereof include triethylenediamine, hexamethylenetetramine, N,N-dimethyloctylamine, N,N,N',N'-tetramethyl-1,6-diaminohexane, 4,4'-trimethylenebis(1-methylpiperidine), 1,8-diazabicyclo-(5,4,0)-7-undecene, dimethyltin dichloride, dimethyltin bis(isooctyl thioglycolate), dibutyltin dichloride, dibutyltin dilaurate, dibutyltin maleate, a dibutyltin maleate polymer, dibutyltin diricinoleate, dibutyltin bis(dodecyl mercaptide), dibutyltin bis(isooctyl thioglycolate), dioctyltin dichloride, dioctyltin maleate, a dioctyltin maleate polymer, dioctyltin bis(butyl maleate), dioctyltin dilaurate, dioctyltin diricinoleate, dioctyltin dioleate, dioctyltin di(6-hydroxy)caproate, dioctyltin bis(isooctyl thioglycolate), didodecyltin diricinoleate, and metal salts such as copper oleate, copper acetylacetone, iron acetylacetone, iron naphthenate, iron lactate, iron citrate, iron gluconate, potassium octanoate, and 2-ethylhexyl titanate.

### (Amidation catalyst)

Any appropriate amidation catalyst to be used in a case in which the microballoon is formed of an amide resin can be used without any limitation. Specific examples thereof include boron or sodium dihydrogen phosphate.

### <Polyurethane (urea) resin containing the microballoon>

When the microballoon according to the present invention is particularly contained in a polyurethane (urea) resin, excellent durability can be exhibited. In the present description, the polyurethane (urea) resin is a generic term for a polyurethane resin, a polyurea resin, and a polyurethane urea resin.

A method for preparing the polyurethane (urea) resin containing the microballoon according to the present invention is not particularly limited, and a known method may be used, and examples thereof include a method of polymerizing a polymerizable composition containing a microballoon and a monomer for forming a polyurethane (urea) resin. More specifically, examples thereof include a method for preparing a polymerizable composition by uniformly mixing and dispersing a compound containing at least two iso(thio)cyanate groups, a compound containing at least two active hydrogen groups having active hydrogen that is polymerizable with an iso(thio)cyanate group (for example, a hydroxy group, a thiol group, and an amino group), and the microballoon according to the present invention and then curing the polymerizable composition. The curing method is not particularly limited, a known method may be adopted, and specific examples of the curing method include a dry method such as a one-pot method and a prepolymer method, and a wet method using a solvent. Among these, the dry method is suitably used. In addition, a known blending material may be added to the polymerizable composition as long as the effects of the present invention are not impaired.

In the polyurethane (urea) resin containing the microballoon according to the present invention, a blending amount of the microballoon according to the present invention into the polyurethane (urea) resin is preferably 0.1 to 30 parts by mass, more preferably 0.2 to 20 parts by mass, and still more preferably 0.5 to 10 parts by mass, per 100 parts by mass of a total amount of the compound containing at least two iso(thio)cyanate groups and the compound containing at least two active hydrogen groups having active hydrogen that is polymerizable with an iso(thio)cyanate group.

A blending amount of the microballoon, when the microballoon according to the present invention is a hollow microballoon described later, is preferably 0.1 to 10 parts by mass, more preferably 0.2 to 8 parts by mass, and still more preferably 0.5 to 8 parts by mass, per 100 parts by mass of the total amount of the compound containing at least two iso(thio)cyanate groups and the compound containing at least two active hydrogen groups having active hydrogen that is polymerizable with an iso(thio)cyanate group.

Within these ranges, excellent polishing characteristics can be exhibited when the microballoon is used in a CMP polishing pad to be described later.

The polyurethane (urea) resin containing the microballoon according to the present invention may have any suitable hardness. The hardness can be measured according to the Shore method, and can be measured, for example, in accordance with JIS (hardness test) K6253. In the present invention, when the polyurethane (urea) resin is used in the CMP polishing pad to be described later, the Shore hardness of the resin is more preferably 40A to 80D, and still more preferably 20D to 70D ("A" indicates a Shore "A" scale, and "D" indicates a hardness on a Shore "D" scale). The hardness can be set to any hardness by changing blending compositions and the blending amount as necessary.

The microballoon according to the present invention is likely to sufficiently maintain performance of a resin to be used. Examples of the method include a comparative method based on a hysteresis loss of the resin to be used for one of evaluation criteria of such performance. In general, when the hysteresis loss of a resin is small, the resin has an excellent elastic recovery property, and when the resin is used in the CMP polishing pad to be described later, a flatness of an object to be polished and a high polishing rate can be exhibited.

The hysteresis loss can be measured, for example, by a method in accordance with JIS K 6251. Specifically, a test piece prepared in a dumbbell shape is elongated by 100%, and then is returned to the previous shape, whereby the hysteresis loss (an area of elongation and stress during elongation and returning to the previous shape/an area of elongation and stress during elongation × 100) can be measured. The "area of elongation and stress during elongation and returning to the previous shape" in the measurement of the hysteresis loss is represented by "an area of a stress-strain curve during elongation - an area of a stress-strain curve during contraction", and the "area of elongation and stress during elongation" means the "area of the stress-strain curve during elongation".

In the present invention, the hysteresis loss is preferably in a range of HB% ≤ H% + 8% and more preferably in a range of HB% ≤ H% + 6% when a hysteresis loss of a resin using the microballoon is HB% and a hysteresis loss of a resin not using the microballoon is H% in a case in which the resin is used in the CMP polishing pad to be described later. That is, the hysteresis loss of the resin to be used does not greatly change depending on the presence or absence of the microballoon, and original physical properties can be utilized. Of course, a difference between the resin using the microballoon and the resin not using the microballoon is only the presence or absence of the microballoon.

A compression ratio of the polyurethane (urea) resin according to the present invention is preferably in a certain range from the viewpoint of exhibiting the flatness of the object to be polished when the polyurethane (urea) resin is used in the CMP polishing pad to be described later. The compression ratio can be measured by a method in accordance with JIS L 1096. In the present invention, the compression ratio is preferably 0.5% to 50%. Within the above-described range, when the polyurethane (urea) resin is used in the CMP polishing pad to be described later, an excellent flatness of the object to be polished can be exhibited.

When the microballoon according to the present invention is a hollow microballoon, the polyurethane (urea) resin according to the present invention is a foam polyurethane (urea) resin, and a density can be adjusted based on a blending amount or the like. In the present invention, the density of the foam polyurethane (urea) resin is preferably 0.60 g/cm³ to 0.95 g/cm³ when the foam polyurethane (urea) resin is used in the CMP polishing pad to be described later.

A method for preparing the foam polyurethane (urea) resin is not particularly limited, and examples thereof may include not only the method for preparing the polyurethane (urea) resin using the hollow microballoon but also include the method of performing the sixth step during the preparation of the polyurethane (urea) resin using microballoons in which an organic solvent remains.

### <CMP polishing pad>

When a CMP polishing pad according to the present invention uses the polyurethane (urea) resin containing the microballoon according to the present invention, a CMP polishing pad in which excellent durability and excellent polishing characteristics are exhibited can be prepared.

As a method for preparing the CMP polishing pad, a known method can be used without limitation. For example, when a method of cutting and surface polishing the polyurethane (urea) resin containing the microballoon according to the present invention is used, a CMP polishing pad having pores on a polished surface of the resin can be prepared. As the microballoon, a hollow microballoon or a microballoon in which an organic solvent remains may be used.

Among these, the microballoon to be used is preferably a hollow microballoon, and thus the CMP polishing pad according to the present invention is a CMP polishing pad using a foam polyurethane (urea) resin.

When a polishing pad includes a plurality of layers, the CMP polishing pad according to the present invention can be applied to any layer, and it is preferred to use the CMP polishing pad according to the present invention at least on a polishing surface that comes into contact with an object to be polished.

The CMP polishing pad according to the present invention can also be a fixed abrasive grain CMP polishing pad containing abrasive grains in addition to the microballoons according to the present invention. Examples of the abrasive grains include particles of a material selected from cerium oxide, silicon oxide, alumina, silicon carbide, zirconia, iron oxide, manganese dioxide, titanium oxide, and diamond, and two or more types of particles of these materials. A method of containing these abrasive grains is not particularly limited, and examples thereof include a method for further uniformly mixing and dispersing these abrasive grains in the polymerizable composition and then curing the polymerizable composition in the method for preparing the polyurethane (urea) resin.

A shape of the CMP polishing pad according to the present invention is not particularly limited, and for example, a groove structure may be formed on a surface of the CMP polishing pad. The groove structure of the CMP polishing pad is preferably a shape that holds and updates a slurry, and specific examples of the groove structure include an X (stripe) groove, an XY grating groove, a concentric circle-shaped groove, a through hole, a blind hole, a polygonal prism, a cylinder, a spiral groove, an eccentric circular groove, a radial groove, and a combination of these grooves.

A method of forming the groove structure of the CMP polishing pad is not particularly limited. Examples of the method include a method of forming a groove structure by pouring the compound or the like into a mold having a predetermined groove structure and curing the compound or the like, a method of forming a groove structure using an obtained resin, a method of performing mechanical cutting using a jig such as a bite having a predetermined size, a method of forming a groove structure by pressing a resin with a press plate having a predetermined surface shape, a method of forming a groove structure by photolithography, a method of forming a groove structure by using a printing method, and a method of forming a groove structure by a laser light using a carbon dioxide laser or the like.

### [Examples]

Next, the present invention will be described in detail with Examples and Comparative Example, and the present invention is not limited to the present Examples. In the following Examples and Comparative Example, the components, the evaluation method, and the like are as follows.

### [Evaluation method]

(1) Amount of polymerizable functional group having reactivity with iso(thio)cyanate group:
   The microballoon according to the present invention was added to butyl isocyanate (or a butyl isocyanate solution having a known concentration), the mixture was sufficiently stirred, and then iso(thio)cyanate groups were quantified by a back titration method in accordance with JIS K 7301. That is, the butyl isocyanate solution obtained by adding the microballoon according to the present invention and sufficiently stirring the mixture, and di-n-butylamine having a clearly excessive amount than an amount of isocyanate groups contained in the butyl isocyanate are added to a dry solvent having no reactivity with the isocyanate groups, and all the isocyanate groups in the butyl isocyanate solution are reacted with di-n-butylamine. Next, di-n-butylamine that was not consumed (not involved in the reaction) was titrated with an acid to determine an amount of the consumed di-n-butylamine, and an amount of butyl isocyanate consumed per 1g of the microballoon was determined. The consumed amount was defined as an amount (mmol/g) of a polymerizable functional group having reactivity with an iso(thio)cyanate group contained in a surface layer of the microballoon.
(2) Particle diameter:
   The microballoon observed with an optical microscope was subjected to image analysis to calculate an average particle diameter.
(3) Bulk density:
   A bulk density was obtained by passing the microballoon through a sieve with 1,000 pm, adding the microballoon to a measuring cylinder having a volume of 100 mL, and tapping the microballoon 1,000 times. Thereafter, the bulk density [g/cm³] was determined based on a volume and a mass of the microballoon in the container.
(4) Ash content:
   An ash content is a ratio of a mass of a combustion residue obtained by combusting the microballoon at a temperature of 600°C to a mass of the microballoon before the combustion. Specifically, the number of parts by mass of the combustion residue when the amount of the microballoon before the combustion was 100 parts by mass was determined.
(5) Shore hardness:
   The Shore hardness was measured using a durometer manufactured by Kobunshi Keiki Co., Ltd. in accordance with JIS (hardness test) K6253.
(6) Hysteresis loss:
   A cured resin punched into a dumbbell shape No. 8 and having a thickness of 2 mm was elongated by 20 mm at 10 mm/min using an AG-SX autograph manufactured by Shimadzu Corporation, and then the hysteresis loss was measured when the stress was returned to zero.
(7) Abrasion resistance:
   A Taber abrasion test of the cured resin was performed, and a Taber abrasion amount was measured. Measurement conditions include a 5130 type device manufactured by Taber Industries. The Taber abrasion test was performed twice at the same location in the same sample under a load of 1 Kg, a rotational speed of 60 rpm, a rotation number of 1,000 times, an abrasion wheel of H-18, and an average value thereof was evaluated. In the table, a Taber abrasion amount (mg) is described as evaluation of abrasion resistance, and it is indicated that the smaller the Taber abrasion amount is, the more excellent the durability is.
(8) Polishing rate:
   The polishing rate when polishing was performed was measured under the following conditions. The polishing rate is an average value often 2-inch sapphire wafers.
   CMP polishing pad: a pad having a size of 500 mmϕ and a thickness of 1 mm in which concentric circle-shaped grooves are formed on a surface
   Slurry: FUJIMI COMPOL 80 stock solution
   Pressure: 4 psi
   Rotation number: 45 rpm
   Time: 1 hour
(9) Surface roughness (Ra):
   Surfaces of the ten 2-inch sapphire wafers at the time of being polished under the conditions described in the above-described (8) were measured for surface roughness (Ra) using a nano search microscope SFT-4500 (manufactured by Shimadzu Corporation). The surface roughness is an average value of the ten 2-inch sapphire wafers.

### <Components>

### (Polymerizable monomer)

Component (A1): polyfunctional isocyanate compound containing at least two isocyanate groups
Component (A12): urethane prepolymer
Pre-1: isocyanate-terminated urethane prepolymer and having iso(thio)cyanate equivalent of 905
Pre-2: isocyanate-terminated urethane prepolymer and having iso(thio)cyanate equivalent of 423

### (Method of preparing Pre-1)

In a flask provided with a nitrogen inlet tube, a thermometer, and a stirrer, 500 g of 2,4-tolylene diisocyanate, 900 g of polyoxytetramethylene glycol (number average molecular weight: 1,000), and 120 g of diethylene glycol were reacted under a nitrogen atmosphere at 80°C for 6 hours, and a isocyanate-terminated urethane prepolymer having an iso(thio)cyanate equivalent of 905 (Pre-1) was obtained.

### (Method of preparing Pre-2)

A isocyanate-terminated urethane prepolymer and having an iso(thio)cyanate equivalent of 423 (Pre-2) was obtained in the same manner as in Preparation Example of Pre-1 except that 585 g of polyoxytetramethylene glycol (number average molecular weight: 650) and 65 g of diethylene glycol were used.
Component (A3): polyfunctional amino compound
TAEA: tris(2-aminoethyl)amine
(Organic solvent)
Tol: toluene
(Emulsifier)
PVA: completely saponified polyvinyl alcohol having average degree of polymerization of about 500

### <Example 1>

### (Microballoon-1)

In 20 parts by mass of toluene, 3 parts by mass of the Pre-2 as the component (A1) was dissolved to prepare a component (a). Next, 6 parts by mass of PVA was dissolved in 100 parts by mass of water to prepare a component (b). Then, the prepared component (a) and component (b) were mixed, and the mixture was stirred under conditions of 25°C and 1,500 rpm for 10 minutes using a high-speed shearing type disperser to prepare an O/W emulsion. An aqueous solution obtained by dissolving 0.4 parts by mass of TAEA in 4 parts by mass of water was added dropwise to the prepared O/W emulsion at 25°C. After the dropwise addition, the mixture was stirred at 60°C for 4 hours to obtain a microballoon dispersion formed of a urethane (urea) resin. The microballoon was taken out of the obtained microballoon dispersion by filtration, dried under vacuum at a temperature of 60°C for 24 hours, and then sieved with a classifier to obtain a hollow microballoon-1.

An amount of a polymerizable functional group having reactivity with an iso(thio)cyanate group contained in a surface layer of the obtained microballoon-1 was 2.5 mmol/g. In addition, the microballoon-1 had a particle diameter of about 20 pm and a bulk density of 0.18 g/cm³, and the ash content was not observed.

### <Example 3>

### (Microballoon-3)

A microballoon-3 was prepared in the same manner as in Example 1 except that 0.32 parts by mass of TAEA was used.

An amount of a polymerizable functional group having reactivity with an iso(thio)cyanate group contained in a surface layer of the obtained microballoon-3 was 0.9 mmol/g. In addition, the microballoon-3 had a particle diameter of about 15 pm and a bulk density of 0.20 g/cm³, and the ash content was not observed.

### <Example 4>

### (Microballoon -4)

Amicroballoon-4 was prepared in the same manner as in Example 1 except that 0.35 parts by mass of TAEA was used.

An amount of a polymerizable functional group having reactivity with an iso(thio)cyanate group contained in a surface layer of the obtained microballoon-4 was 1.7 mmol/g. In addition, the microballoon-4 had a particle diameter of about 20 pm and a bulk density of 0.19 g/cm³, and the ash content was not observed.

### <Reference Example 1>

### (Microballoon-2)

A microballoon-2 was a commercially available microcapsule 920-40 (hollow microballoon formed of an acrylonitrile resin obtained by dazzling inorganic powders on a surface, manufactured Japan Fillite Co., Ltd.), and an amount of a polymerizable functional group having reactivity with an iso(thio)cyanate group was 0 mmol/g. The particle diameter was 40 pm, the bulk density was 0.03 g/cm³, and the ash content was 1.87 parts by mass.

### <Example 2>

### (Method for preparing CMP polishing pad using microballoon)

12 parts by mass of 4,4'-methylene bis(o-chloroaniline) (MOCA) was sufficiently degassed to prepare a solution A. Separately, 3.3 parts by mass of the microballoon-1 obtained in Example 1 was added to 88 parts by mass of the Pre-1 prepared as described above and heated to 70°C, and the mixture was stirred with a rotation and revolution type stirrer to prepare a uniform solution. The solution A adjusted to 100°C was added to the uniform solution, and the mixture was stirred with the rotation and revolution type stirrer to obtain a uniform polymerizable composition. The polymerizable composition was injected into a mold and cured at 100°C for 15 hours to obtain a polyurethane (urea) resin containing the microballoon.

The obtained polyurethane (urea) resin was sliced to obtain a CMP polishing pad using the polyurethane (urea) resin having a thickness of 1 mm to be shown later.

Separately, a microballoon-free polyurethane (urea) resin was prepared by performing the same operation as described above except that no microballoon was added. The microballoon-free polyurethane (urea) resin was not used for CMP polishing, and was only used for confirming physical properties of the resin.

For the polyurethane (urea) resin containing the microballoon obtained above, the density was 0.87 g/cm³, the Shore hardness was 50D, the hysteresis loss was 65%, and the abrasion resistance was 58 mg, the polishing rate of the CMP polishing pad obtained above was 2.0 pm/hr, and the surface roughness after polishing of a wafer to be polished was 0.22 nm. In addition, the microballoon-free polyurethane (urea) resin had a Shore hardness of 55D, a hysteresis loss of 60%, and an abrasion resistance of 50 mg.

### <Examples 5 and 6 and Comparative Example 1>

A CMP polishing pad using a polyurethane (urea) resin was prepared and evaluated in the same manner as in Example 2 except that compositions shown in Table 1 were used. Results are shown in Table 1.

As can be seen from the results in Table 1, the CMP polishing pad using the microballoon according to the present invention can exhibit excellent durability, excellent resin physical properties, and polishing characteristics such as a polishing rate or smoother polishing for a wafer to be polished.

**[Table 1]**

| | Microballoon (part by mass) | Urethane resin composition (part by mass) | Microballoon added urethane resin | | | | CMP polishing pad | | Microballoon-free urethane resin | | |
|---|---|---|---|---|---|---|---|---|---|---|---|
| | | | Density g/cm³ | Shore hardness | Hysteresis loss HB% | Abrasion resistance mg | Polishing rate µm/hr | Surface roughness (Ra) nm | Shore hardness | Hysteresis loss H% | Wear resistance mg |
| Example 2 | Microballoon-1 (prepared in Example 1) (3.3) | Pre-1 (88) MOCA (12) | 0.87 | 50D | 65 | 58 | 2.0 | 0.22 | 55D | 60 | 50 |
| Example 5 | Microballoon-3 (prepared in Example 3) (3.3) | Pre-1 (88) MOCA (12) | 0.90 | 51D | 66 | 58 | 1.5 | 0.27 | 55D | 60 | 50 |
| Example 6 | Microballoon-4 (prepared in Example 4) (3.3) | Pre-1 (88) MOCA (12) | 0.89 | 50D | 65 | 59 | 1.9 | 0.24 | 55D | 60 | 50 |
| Comparative Example 1 | Microballoon-2 (Reference Example 1) (0.8) | Pre-1 (88) MOCA (12) | 0.80 | 51D | 70 | 75 | 1.0 | 0.32 | 55D | 60 | 50 |

## Claims

1. A microballoon comprising a surface layer and having a particle diameter of 10 pm to 200 pm, the surface layer having a polymerizable functional group having reactivity with an iso(thio)cyanate group.

2. The microballoon according to claim 1, wherein
the polymerizable functional group having reactivity with an iso(thio)cyanate group comprises at least one group selected from the group consisting of a hydroxy group, an amino group, and a thiol group.

3. The microballoon according to claim 1 or 2, wherein
an amount of the polymerizable functional group having reactivity with an iso(thio)cyanate group contained in the surface layer is 0.75 mmol/g or more per unit weight of the microballoon.

4. The microballoon according to any one of claims 1 to 3, formed of at least one resin selected from the group consisting of a urethane (urea) resin, a melamine resin, a urea resin, and an amide resin.

5. The microballoon according to any one of claims 1 to 4, having an ash content of 0.5 parts by mass or less per 100 parts by mass of the microballoon.

6. The microballoon according to any one of claims 1 to 5, having a bulk density of 0.01 g/cm³ to 0.5 g/cm³.

7. A polyurethane (urea) resin comprising the microballoon according to any one of claims 1 to 6.

8. A CMP polishing pad comprising the polyurethane (urea) resin according to claim 7.

9. The CMP polishing pad according to claim 8, wherein
the polyurethane (urea) resin has a Shore hardness of 40A to 80D and a density of 0.60 g/cm³ to 0.95 g/cm³.
